(19) Europäisches Patentamt
European Patent Office
Office européen des brevets

(11) **EP 3 477 843 B1**

(12) **EUROPEAN PATENT SPECIFICATION**

(45) Date of publication and mention
of the grant of the patent:
**29.07.2020 Bulletin 2020/31**

(51) Int Cl.:
*H02M 5/458* (2006.01)      *H02M 7/5387* (2007.01)
*G01R 31/50* (2020.01)      *G01R 31/42* (2006.01)
*H02M 1/32* (2007.01)       *H02M 1/08* (2006.01)
*G01R 27/26* (2006.01)      *G01R 31/08* (2020.01)
*H02P 23/00* (2016.01)      *H02M 1/00* (2006.01)

(21) Application number: **17814925.8**

(22) Date of filing: **10.02.2017**

(86) International application number:
**PCT/JP2017/005000**

(87) International publication number:
**WO 2017/221453 (28.12.2017 Gazette 2017/52)**

(54) **POWER CONVERSION DEVICE AND METHOD FOR DETERMINING GROUND FAULT SITE**

LEISTUNGSUMWANDLUNGSVORRICHTUNG UND -VERFAHREN ZUR BESTIMMUNG VON ERDSCHLUSSSTELLEN

DISPOSITIF DE CONVERSION DE PUISSANCE ET PROCÉDÉ DE DÉTERMINATION D'UN SITE DE DÉFAUT À LA TERRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.06.2016 JP 2016124241**

(43) Date of publication of application:
**01.05.2019 Bulletin 2019/18**

(73) Proprietor: **Hitachi Industrial Equipment Systems Co., Ltd.**
**Chiyoda-ku**
**Tokyo 101-0022 (JP)**

(72) Inventors:
• **KAGEYAMA, Hiroshi**
**Tokyo 100-8280 (JP)**
• **SASAKI, Yasushi**
**Tokyo 101-0022 (JP)**
• **TOMIYAMA Kiyotaka**
**Tokyo 101-0022 (JP)**

(74) Representative: **Mewburn Ellis LLP**
**Aurora Building**
**Counterslip**
**Bristol BS1 6BX (GB)**

(56) References cited:
**JP-A- H0 666 901          JP-A- 2002 136 148**
**JP-A- 2002 140 123      US-A1- 2008 084 215**
**US-A1- 2013 293 988**

**Description**

Technical Field

The present invention relates to a power conversion device for driving a motor and a method for determining a ground fault site of a cable or a motor using the power conversion device.

Background Art

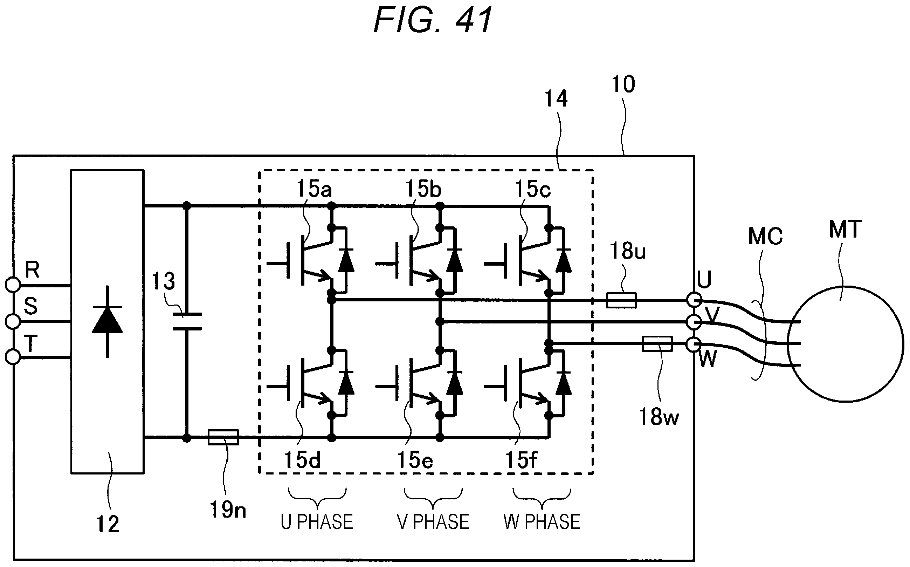

An example of a power conversion device, a motor, and cables connecting these components of the related art is illustrated in FIG. 41. A power conversion device 10 of the related art includes a converter circuit 12 which receives an AC power and supplies power to a motor, a smoothing capacitor 13, and an inverter circuit 14. The converter circuit 12 is configured by six diodes, and converts the AC power input from input terminals R, S, and T into a DC power. The smoothing capacitor 13 is connected to a DC voltage line in the converter device, and smoothens a voltage between lines. The inverter circuit 14 converts the DC power to the AC power to drive the motor, and outputs the AC power to output terminals U, V, and W. The inverter circuit 14 includes switch elements 15a to 15f formed of semiconductor. Two switch elements pair up with each other to form a half bridge circuit, and six switch elements forms a three-phase bridge circuit of U, V, and W. The upper and lower switch elements of one phase are alternately switched ON not to be turned ON at the same time. The outputs U, V, and W of the respective phases are connected to the motor MT using three cables MC. The power conversion device 10 of the related art controls the power to be supplied to the motor by PWM control in which a turning ON time of each switch element is changed on the basis of current information observed by current sensors 18u and 18w or a current sensor 19n.

In a case where a short circuit or a ground fault occurs inside the motor MT or in the cable MC due to some cause such as a degradation in an insulating cover or a physical damage, an overcurrent is detected by the current sensor 19n or an overcurrent detection circuit (not illustrated) which is attached between an emitter and a collector of each switch element and monitors a collector voltage. In a case where the overcurrent is detected, the conversion operation is stopped by turning OFF all the switch elements in order to prevent the switch elements from being broken by thermal energy generated by a large current.

Citation List

Patent Literature

PTL 1: JP 10-23795 A

Summary of Invention

Technical Problem

In a case where the power conversion device is stopped by a short circuit between lines or a ground fault, it can be notified that there occurs a ground fault by notifying the information to a user. However, in a case where the power conversion device is stopped by an accident of a short circuit or a ground fault, the user is not able to specify whether the short circuit or the ground fault occurs on the cable or in the motor, or a site where the accident occurs.

As a method for acquiring information of an abnormality occurring site, PTL 1 introduces a method in which total two switching elements of an upper arm and a lower arm are turned ON in a short time after the short circuit occurs so as to estimate the site by viewing a slope of the current. In this case, the slope of the current is determined by an inductance L of the short-circuit path. Therefore, the short-circuit site can be estimated on the basis of the inductance L. However, the configuration of PTL 1 cannot cope with specifying a ground fault site. There are two main reasons. The first reason is that a cause for generating the current is different. In the configuration of PTL 1, while an electromotive force causing the current is a DC voltage in the converter, an electromotive force causing a ground fault current is a voltage to ground of the converter and an input power line. These voltages are changed by a length of the input power line and by an input AC voltage. Therefore, the current value also significantly varies by the influence, and the inductance can be obtained from the slope of the current. The second reason is that another element is added to the current path. In an interphase short circuit, the current path includes only the cable and the motor. In the ground fault, components having an indefinite inductance value such as the earth, a power source line, and a transformer. Therefore, the inductance value obtained from the slope of the current contains all these inductance values, and thus it is hard to estimate the necessary inductance values of the cable and the motor. US 2013/0293988 A1 proposes a system and method for detecting ground faults in an AC motor drive. US 2008/0084215 A1 proposes an inverter in which insulation defects are detected by way of a differential voltage.

An object of the invention is to provide a power conversion device which determines a ground fault site on the motor and the cable, and notifies a determination result to a user, an external device, and a system.

Solution to Problem

Accordingly, in a first aspect, the invention provides a power conversion device as set out in claim 1. In a second aspect, the invention provides a method for determining a ground fault as set out in claim 14, Further preferred embodiments are set out in the dependent claims.

Advantageous Effects of Invention

According to the invention, it is possible to specify and determine a ground fault site with respect to an accident of a ground fault occurring in a motor and a cable. Further, the ground fault site can be notified to a user, an external device, and an external system by displaying the determination result of the ground fault site in a display device or by transmitting the determination result in a wireless manner.

Brief Description of Drawings

[FIG. 1] FIG. 1 is a diagram illustrating a configuration of a first embodiment of the invention.
[FIG. 2] FIG. 2 is a flowchart of determining a site of a ground fault in the first embodiment of the invention.
[FIG. 3] FIG. 3 is a flowchart of a ground fault current inspection.
[FIG. 4] FIG. 4 is a diagram illustrating states of switches at a current ratio calculation S112 and before and after the calculation, and an example of output current waveforms.
[FIG. 5] FIG. 5 is a diagram illustrating states of switches at a current ratio calculation S115 and before and after the calculation, and an example of output current waveforms.
[FIG. 6] FIG. 6 is an example of a current path between time t1 and time t2 of FIG. 4.
[FIG. 7] FIG. 7 is an example of a current path between time t3 and time t4 of FIG. 5.
[FIG. 8] FIG. 8 is an equivalent circuit of the current path illustrated in FIG. 6.
[FIG. 9] FIG. 9 is an equivalent circuit of a transformer in which one of three-phase output terminals is grounded.
[FIG. 10] FIG. 10 is a diagram illustrating voltages to ground of R, S, and T phases of the secondary three-phase outputs of the transformer when the output in FIG. 9 is in an open state.
[FIG. 11] FIG. 11 is an equivalent circuit of the transformer of which the neutral point is grounded.
[FIG. 12] FIG. 12 is a diagram illustrating the voltages to ground of R, S, and T phases of the secondary three-phase outputs of the transformer when the output in FIG. 11 is in the open state.
[FIG. 13] FIG. 13 is a diagram illustrating a determination method used in a ground fault site estimating unit 123.
[FIG. 14] FIG. 14 is an exemplary configuration of a display device 108.
[FIG. 15] FIG. 15 is a table illustrating a correspondence relation between a display pattern displayed in an LED segment and a ground fault site.
[FIG. 16] FIG. 16 is a diagram illustrating a configuration of a transmitter 109.
[FIG. 17] FIG. 17 is an exemplary configuration of a switch drive circuit.
[FIG. 18] FIG. 18 is a flowchart of the current ratio calculations S112 and S115.
[FIG. 19] FIG. 19 is a diagram illustrating an example of short-circuit current waveforms at different current increasing speeds.
[FIG. 20] FIG. 20 is a diagram illustrating a configuration of a second embodiment of the invention.
[FIG. 21] FIG. 21 is a flowchart illustrating a current ratio calculation used in the second embodiment of the invention.
[FIG. 22] FIG. 22 is another flowchart of the determination on the site of the ground fault in the second embodiment of the invention.
[FIG. 23] FIG. 23 is a flowchart of a ground fault current inspection which is performed in FIG. 22.
[FIG. 24] FIG. 24 is a diagram illustrating states of switches at a current ratio calculation S313u and before and after the calculation, and an example of output current waveforms.
[FIG. 25] FIG. 25 is a diagram illustrating states of switches at a current ratio calculation S316u and before and after the calculation, and an example of output current waveforms.
[FIG. 26] FIG. 26 is an example of the current path between time t1 and time t2 of FIG. 24.
[FIG. 27] FIG. 27 is an example of the current path between time t3 and t4 of FIG. 25.
[FIG. 28] FIG. 28 is an equivalent circuit of the current path illustrated in FIG. 26.

[FIG. 29] FIG. 29 is a diagram illustrating a determination method used in a ground fault site estimating unit 223.

[FIG. 30] FIG. 30 is a flowchart of U-W current ratio calculations S313u and S316u denoted in FIG. 23.

[FIG. 31] FIG. 31 is a flowchart of V-W current ratio calculations S313v and S316v denoted in FIG. 23.

[FIG. 32] FIG. 32 is a diagram illustrating a configuration of a third embodiment of the invention.

[FIG. 33] FIG. 33 is an equivalent circuit of the transformer in which one of single-phase output terminals is grounded.

[FIG. 34] FIG. 34 is a diagram illustrating the voltages to ground of R and S phases of the secondary three-phase outputs of the transformer when the output in FIG. 33 is in the open state.

[FIG. 35] FIG. 35 is an equivalent circuit of the transformer of which the neutral point is grounded.

[FIG. 36] FIG. 36 is a diagram illustrating the voltages to ground of R and S phases of the secondary three-phase outputs of the transformer when the output in FIG. 35 is in the open state.

[FIG. 37] FIG. 37 is a diagram illustrating an example in which the invention is applied to an industrial inverter.

[FIG. 38] FIG. 38 is a diagram illustrating an example in which the invention is applied to a railway vehicle.

[FIG. 39] FIG. 39 is a diagram illustrating an example in which the invention is applied to a vehicle equipped with an electric motor.

[FIG. 40] FIG. 40 is a diagram illustrating an example of a tablet terminal which displays a determination result of a ground fault site of the invention.

[FIG. 41] FIG. 41 is a diagram illustrating an example where a power conversion device of the related art, a motor, and connecting cables therebetween.

Description of Embodiments

While being described below using the drawings, embodiments below are not limited to the illustrated examples.

[First embodiment]

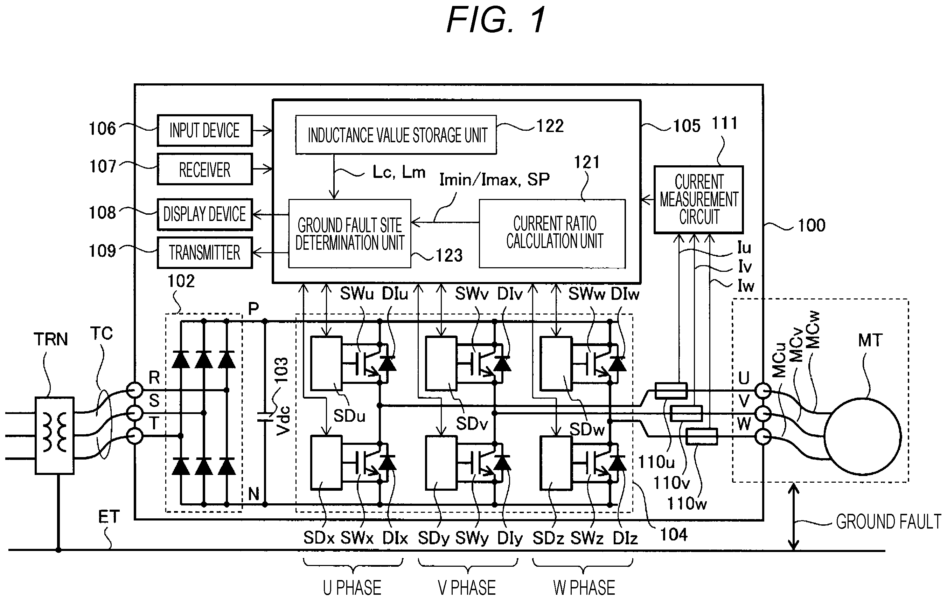

FIG. 1 illustrates a diagram illustrating a configuration of a first embodiment of a power conversion device of the invention. A power conversion device 100 includes a converter circuit 102, a smoothing capacitor 103, and an inverter circuit 104 in order to receive an AC power and to supply power to a motor. In addition, the power conversion device 100 includes a control circuit 105 to control the inverter circuit 104, an input device 106 through which information is manually input to the control circuit 105, a receiver 107 to receive signals from an external system, a display device 108 to display output information from the control circuit 105, and a transmitter 109 to transmit signals to the external system.

The converter circuit 102 is configured by six diodes, converts the AC power input from input terminals R, S, and T into a DC power, and outputs the DC power to both electrode of the smoothing capacitor 103. With the rectification of the diodes of the converter circuit 102, a DC voltage $V_{dc}$ is generated in which a positive voltage is applied to a DC voltage line on the Node-P side, and a negative voltage is applied to a DC voltage line on the Node-N side. The smoothing capacitor 103 is connected to the DC voltage line at Nodes P and N, and smoothens the voltage between the lines. The inverter circuit 104 converts the DC power into the AC power to drive the motor, and outputs the AC power to output terminals U, V, and W.

The inverter circuit 104 is configured by three half bridge circuits of U-phase, V-phase, and W-phase. The half bridge circuit of U-phase is configured by an upper arm in which a switch SWu and a diode DIu are connected in reverse parallel, and a lower arm in which a switch SWx and a diode DIx are connected in reverse parallel. Similarly, the half bridge circuit of V-phase is configured by a switch SWv and a diode DIv, and a switch SWy and a diode DIy. The half bridge circuit of W-phase is configured by a switch SWw and a diode DIw, and a switch SWz and a diode DIz. While IGBTs are used as switching elements in FIG. 1, MOSFETs may be used. In addition, while silicon is normally used as a semiconductor device, a wide-gap semiconductor such as SiC (silicon carbide) or GaN (gallium nitride) may be used in order to reduce loss. In all the switches SWu, SWv, SWw, SWx, SWy, and SWz, switch drive circuits SDu, SDv, SDw, SDx, SDy, and SDz are connected respectively. Each switch drive circuit is connected to the electrodes of emitter, gate, and collector of each switch. The emitter, the gate, and the collector are the electrode names of the IGBT, and correspond to the electrode names of source, gate, and drain in the case of the MOSFET. In all the switch drive circuits, there are built in a gate driver circuit which switches ON and OFF the switch by controlling gate voltage of the switch, and an overcurrent protection circuit which detects an overcurrent flowing in the switch to block (turns OFF) the switch at a high speed. Each switch drive circuit includes a communication unit to the control circuit 105. The communication unit is used to transfer ON/OFF control signals of the switch from the control circuit 105 to the switch drive circuit, and to transfer an overcurrent detection signal from the switch drive circuit to the control circuit 105.

The power conversion device 100 includes three current sensors 110u, 110v, and 110w which measure output current values of the respective phases, and a current measurement circuit 111 which is used to measure these measurement values between the inverter circuit 104 and the output terminals U, V, and W. The current sensors 110u, 110v, and 110w measure the current values Iu, Iv, and Iw which are output from the output terminals U, V, and W, and transfer the current values as analog voltages or currents to the current measurement circuit 111. The current measurement circuit 111 samples the analog information, and converts the information into digital data, and transfer the digital data to the control circuit 105. The current measurement circuit 111 may be configured by a general sampling circuit and an A/D conversion circuit. Further, when being described about the output current value, the symbol of the current value generally represents a current direction (absorption/discharge). However, in the description of the embodiments of the invention, the current direction is any one of absorption and discharge, and thus the current values Iu, Iv, and Iw will be denoted using a positive value with respect to both absorption and discharge directions (that is, an absolute value).

The control circuit 105 includes a current ratio calculation unit 121, an inductance value storage unit 122, and a ground fault site determination unit 123. The current ratio calculation unit 121 transmits, to the ground fault site determination unit 123, a phase number SP of a maximum current phase and a current ratio Imin/Imax of a current Imax of the maximum current phase to a current Imin of a minimum current phase on the basis of current value data sent from the current measurement circuit 111 and a short-circuit detection signal from each switch drive circuit. The ground fault site determination unit 123 estimates a ground fault site on the basis of the information SP and the current Imin/Imax transmitted from the current ratio calculation unit, and an inductance value Lc of a motor cable MC and an inductance value Lm of an internal motor winding which are stored in the inductance value storage unit 123. The determination result is transmitted to the display device 108 and the transmitter 109.

Further, the control circuit 105 has general functions for driving the motor in a PWM system which is not related to the operation of the invention, and thus the description thereof will be omitted. In addition, elements which can be configured only by logic circuits such as the current ratio calculation unit 121, the inductance value storage unit 122, and the ground fault site determination unit 123 in the control circuit 105 may be realized by software using a microcomputer or a programmable logic.

The output terminals U, V, and W of the power converter 100 are connected to three motor cables MCu, MCv, and MCw, and then connected to a three-phase motor MT. On the other hand, the input terminals R, S, and T of the power converter 100 are connected to three power cables TC, and then connected to the secondary side of a transformer TRN. The inner portion of the transformer TRN or any one of the cables TC is connected to the earth ET or a grounded line.

In a case where a ground fault occurs between the motor cables MCu, MCv, and MCw or three-phase motor MT surrounded by a broken line and the earth ET, the power conversion device of the first embodiment of the invention can estimate a ground fault site.

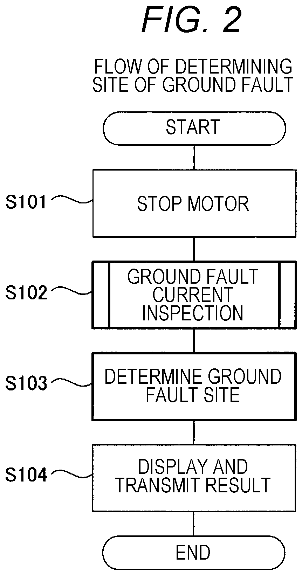

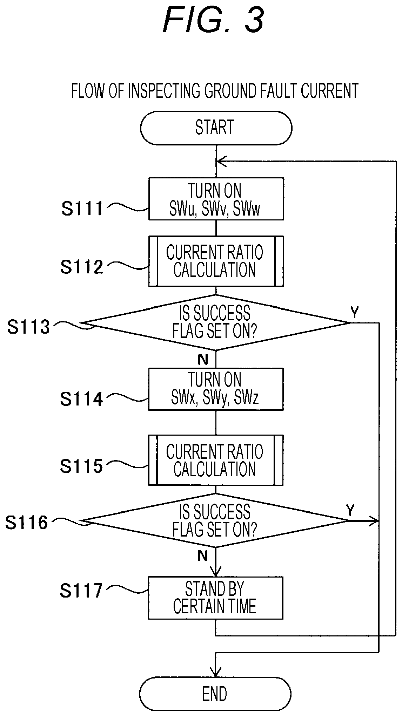

FIG. 2 illustrates a flowchart of determining a site of a ground fault in the first embodiment of the invention. The flow of FIG. 2 starts with the overcurrent detection signal from a protection circuit in accordance with the ground fault occurrence and a trigger signal from the input device 106 or the receiver 107. After starting, the control circuit 105 preforms a motor stop action (S101). Specifically, all the switches of the converter circuit 104 are turned OFF to stop the power supply to the motor, and are on standby until the current value of all phases calculated by the current measurement circuit 111 becomes "0" . After the motor is stopped, the control circuit 105 performs a ground fault current inspection. The current ratio calculation unit 121 outputs the current ratio Imin/Imax and the phase number SP of the maximum current phase (S102). Herein, the flow of the ground fault current inspection illustrated in FIG. 3 is performed. Thereafter, the ground fault site is determined on the basis of these pieces of information, and the inductance value Lc of the motor cable and the inductance value Lm of the internal motor winding stored in the inductance value storage unit 123 (S103) . The determination result is transmitted to the display device 108 and the transmitter 109 (S104).

FIG. 3 illustrates a flowchart of the ground fault current inspection. In the beginning, the control circuit 105 turns ON all the switches SWu, SWv, and SWw of the upper arm (S111). Thereafter, the control circuit 105 specifies a phase flowing with the maximum current on the basis of the measured current value, and calculates the current ratio Imin/Imax (S112). In a case where the current is measured sufficient to the calculation, and the calculation of the current ratio is successful, the flow ends (S113) . In a case where the current is not measured sufficient to the current ratio calculation S112, all the switches are once turned OFF, and the switches SWx, SWy, and SWz of the lower arm are turned ON this time (S114). Thereafter, the control circuit 105 specifies a phase flowing with the maximum current on the basis of the measured current value, and calculates the current ratio Imin/Imax (S115). In a case where the current is measured sufficient to the calculation, and the calculation of the current ratio is successful, the flow ends (S116) . In a case where the current is not measured sufficient to the current ratio calculation S115, the flow is on standby for a certain period of time (S117). Thereafter, the flow restarts from the first step.

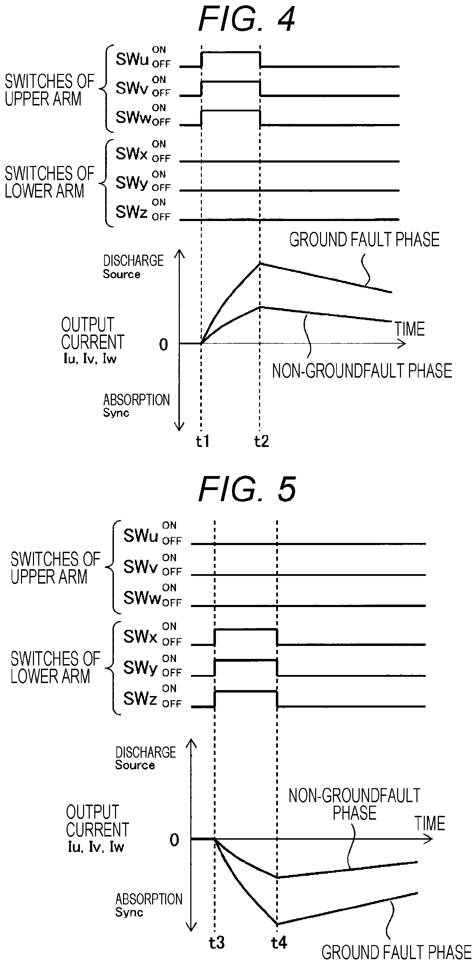

FIG. 4 illustrates states of the switches at the current ratio calculation S112 and before and after the calculation, and output current waveforms. When the switches SWu, SWv, and SWw of the upper arm are turned ON at time t1, the discharge current is generated at the output of each phase. While the current is increased as time goes by, the current of the phase having the ground fault is increased steeply more than the current of a phase having no ground fault. As a result, the current of the phase having the ground fault is kept higher than the current of the phase having no ground fault. This state is kept until all the switches are turned OFF at time t2.

FIG. 5 illustrates states of the switches at the current ratio calculation S115 and before and after the calculation, and an example of output current waveforms. When the switches SWx, SWy, and SWz of the lower arm are turned ON at time t3, the absorption current is generated at the output of each phase. While the current is increased as time goes by, the current of the phase having the ground fault is increased steeply more than the current of a phase having no ground fault. As a result, the current of the phase having the ground fault is kept higher than the current of the phase having no ground fault. This state is kept until all the switches are turned OFF at time t4.

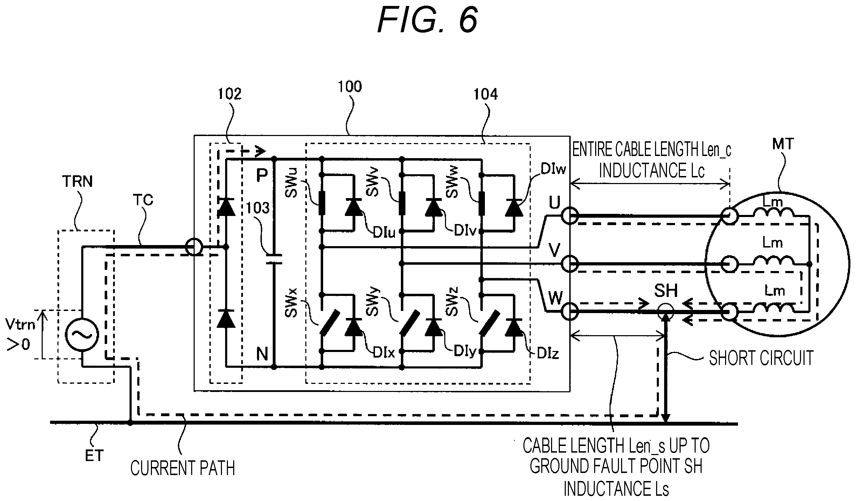

FIG. 6 illustrates an example of the current path of the current between time t1 and time t2 illustrated in FIG. 4. In FIG. 6, there is illustrated a situation where the ground fault occurs on the motor cable (ground fault point SH) of W-phase as an example. An electromotive force causing the current is a voltage to ground Vtrn of the output (secondary side) of the transformer. While the output of the transformer is a three-phase output, the current flows in from the phase having the positive voltage to ground Vtrn by the diodes of the converter circuit 102. In a case where there are plural phases having the positive voltage to ground Vtrn, the current flows in from the plural phases. However, for the sake of simplicity in the explanation, only one phase set of the transformer TRN, the power cable TC, and the diodes of the converter circuit 102 is illustrated in FIG. 6. The current, which is supplied from the transformer TRN and flows into through the diodes of the converter circuit 102, passes through the turned-ON three switches SWu, SWv, and SWw of the upper arm in the inverter circuit 104 via Node P, and are divided into three currents. The divided currents are joined at the ground fault point SH through the output terminals U, V, and W. The joined current flows in the earth ET and returns to the transformer TRN. Further, while not illustrated in the drawing, after all the switches are turned OFF at time t2, the current path is partially changed to be a route in which the current goes to Node N through the smoothing capacitor 103 from Node P, and then is divided into three through the diodes DIx, DIy, and DIz of the lower arm. Since the DC voltage Vdc is charged in the smoothing capacitor, the current is reduced by that voltage.

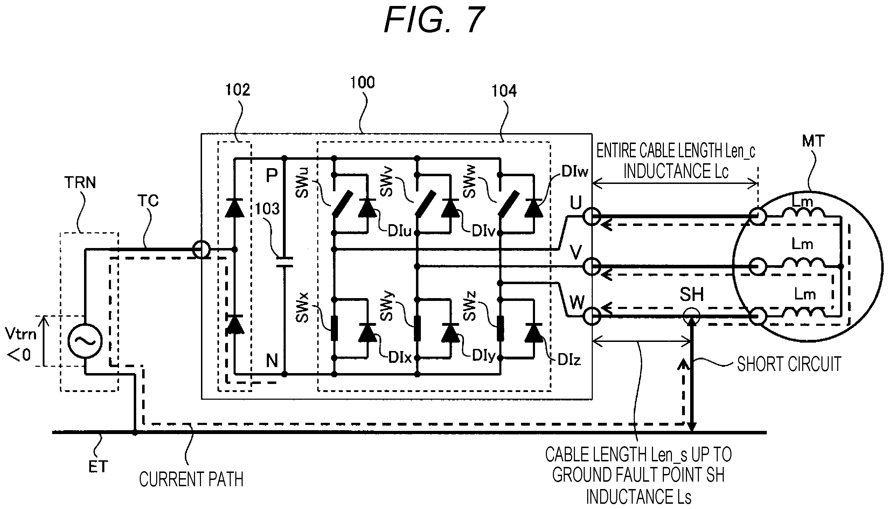

FIG. 7 illustrates an example of the current path of the current between time t3 and t4 illustrated in FIG. 5. In FIG. 7, there is illustrated a situation where the ground fault occurs on the motor cable of W-phase (the ground fault point SH) as an example. An electromotive force causing the current is a voltage to ground Vtrn of the output (secondary side) of the transformer. While the output of the transformer is a three-phase output, the current flows in from the converter circuit 102 to the phase having the negative voltage to ground of the transformer TRN by the diodes of the converter circuit 102. In a case where there are plural phases having the negative voltage to ground, the current flows to the plural phases. However, for the sake of simplicity in the explanation, only one phase set of the transformer TRN, the power cable TC, and the diodes of the converter circuit 102 is illustrated in FIG. 7. The current output from the transformer TRN flows in the earth ET and reaches the ground fault point SH, and is divided into three to flow to the output terminals U, V, and W. The divided currents flow in the turned-ON three switches SWx, SWy, and SWz of the lower arm in the inverter circuit 104, are joined at Node N, and return to the converter circuit 102. Further, while not illustrated in the drawing, after all the switches are turned OFF at time t4, the current path is partially changed to be a route in which the three divided currents are joined through the diodes DIu, DIv, and DIw of the upper arm, and go to Node N through the smoothing capacitor 103 from the current Node P. Since the DC voltage Vdc is charged in the smoothing capacitor, the current is reduced by that voltage.

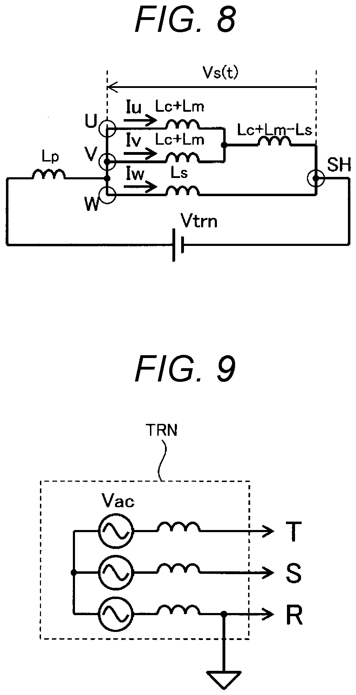

FIG. 8 illustrates an equivalent circuit of the current path illustrated in FIG. 6. "Vtrn" represents a potential to ground of the output of the transformer TRN, and "Lp" represents a series inductance (a sum of the inductances) of the inductances of the earth ET, the transformer TRN, and the power cable TC. "Lc" and "Lm" represent an inductance of the motor cable and an inductance of the internal motor winding respectively as illustrated in FIG. 6. Further, "Ls" represents an inductance up to the output terminal W and a ground fault site SH as illustrated in FIG. 6.

"Iw" representing a short-circuit phase is described in Expression 1.

$$Iw = \int Vs(t)dt/Ls \qquad \text{(Expression 1)}$$

Herein, Vs (t) represents voltages between the terminals U, V, and W and the ground fault point SH. On the other hand, "Iu" and "Iv" representing a non-short-circuit phase are described in Expression 2.

$$Iu = Iv = \int Vs(t)dt/(3Lc + 3Lm - 2Ls) \qquad \text{(Expression 2)}$$

The current ratio of the short-circuit phase and the non-short-circuit phase is obtained as Expression 3, and becomes a constant value regardless of time t.

$$Iu/Iw = Iv/Iw = Ls/(3Lc + 3Lm - 2Ls) \qquad \text{(Expression 3)}$$

Herein, in a case where the ground fault occurs on the cable, Ls < Lc is satisfied, so that Iu/Iw = Iv/Iw < 1 (that is, Iu = Iv < Iw) is satisfied, and the current of the ground fault phase always becomes larger than the current of the non-ground-fault phase. Therefore, if the inspection is made on a phase having the largest current among the three phases, it can be seen that the largest current flows to the ground fault phase.

In a case where the ground fault point SH is at the end of the motor cable, Ls = Lc is satisfied. At this time, the current ratio is obtained as Expression 4.

$$Iu/Iw = Iv/Iw = Lc/(Lc + 3Lm) \qquad (Expression\ 4)$$

Even in this case, Iu/Iw = Iv/Iw < 1 (that is, Iu = Iv < Iw) is satisfied, and the current of the ground fault phase always becomes larger than the current of the non-ground-fault phase.

In addition, FIG. 6 illustrates that the ground fault point SH is on the cable, but it can be said that there is no difference even when the ground fault point is on the internal winding of the motor. In a case where the ground fault point SH is on the internal winding of the motor, Lc < Ls < Lc + Lm is satisfied. Even in the condition of "Lc", Iu/Iw = Iv/Iw < 1 (that is, Iu = Iv < Iw) is satisfied, and the current of the ground fault phase always becomes larger than the current of the non-ground-fault phase. In addition, an equivalent circuit of the current path illustrated in FIG. 7 is also equal to that in FIG. 8. Even though the directions of the currents Iu, Iv, and Iw are opposite, there is no difference from the above description as a result.

By the way, at least one of the voltages to ground of the three-phase outputs of the transformer TRN is necessarily positive in order to measure the sufficient current and to be successful in the current ratio calculation S112. In addition, at least one of the voltages to ground of the three-phase outputs of the transformer TRN is necessarily negative in order to measure the sufficient current and to be successful in the current ratio calculation S115.

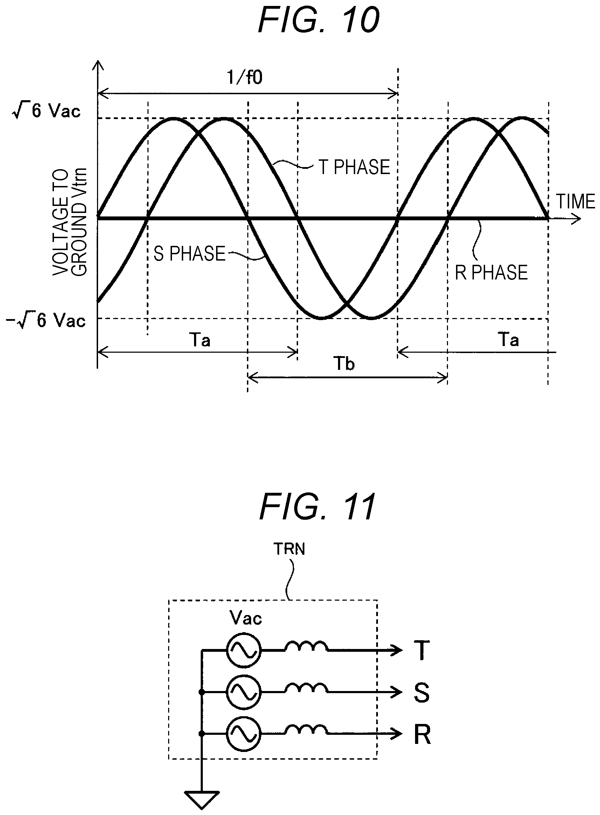

FIG. 9 is an equivalent circuit of the transformer in which one of three-phase output terminals is grounded and a phase voltage is "Vac". At this time, the voltages to ground of R, S, and T phases of the secondary three-phase outputs of the transformer TRN when the output is in an open state are obtained as illustrated in FIG. 10. "f0" is a fundamental frequency of an AC power source, and is normally about several tens Hz. One period (= 1/f0) of an AC power source voltage includes Period Ta in which there are one or more phases having positive voltages to ground in the three phases, and Time Tb in which there are one or more phases having negative voltages to ground in the three phases. In a case where the switches of the upper arm are turned ON in Period Ta to perform the current ratio calculation S112, the sufficient current can be measured, and the current ratio calculation can be successful. In addition, in a case where the switches of the lower arm are turned ON in Period Tb to perform the current ratio calculation S115, the sufficient current can be measured, and the current ratio calculation can be successful. Since Period Ta and Period Tb are in a complementary relation in one period of the AC power source, as illustrated in the flowchart of FIG. 3, the current ratio calculation can be made successful at any timing by continuously performing the current ratio calculation S112 when the switches of the upper arm are turned ON and the current ratio calculation S115 when the switches of the lower arm are turned ON.

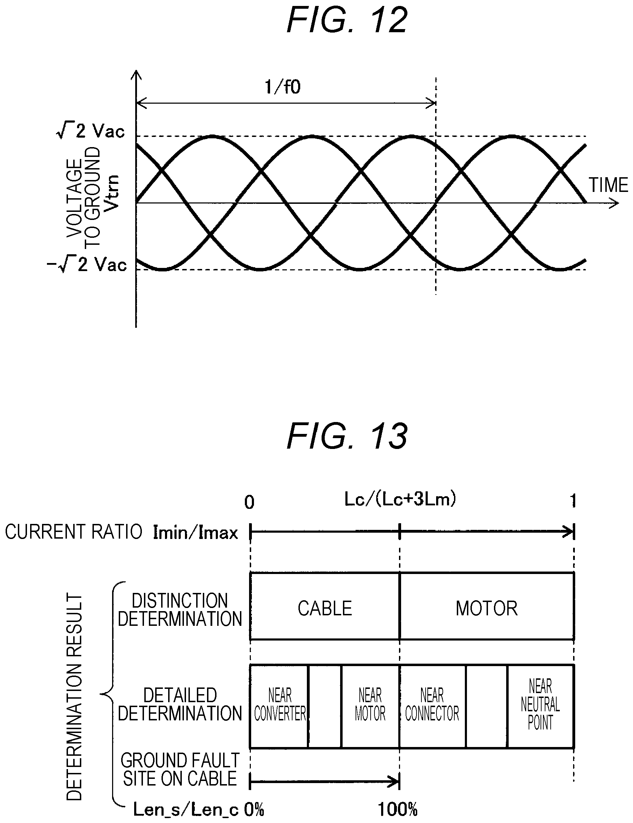

FIG. 11 is an equivalent circuit of the transformer in which the neutral point is grounded and a phase voltage is "Vac". At this time, the voltages to ground of R, S, and T phases of the secondary three-phase outputs of the transformer TRN when the output is in the open state are obtained as illustrated in FIG. 12. Since there are phases having one or more positive and negative voltages to ground in the three phases at any time, the sufficient current can be obtained and the current ratio calculation can be successful in any of the current ratio calculation S112 when the switches of the upper arm are turned ON and the current ratio calculation S115 when the switches of the lower arm art turned ON. Therefore, as illustrated in FIG. 11, even in a case where the neutral point of the transformer TRN is grounded, the current ratio can be calculated by the flowchart illustrated in FIG. 3, but the processes S111 to S113 or the processes S114 to S116 may be omitted.

FIG. 13 illustrates a determination method used by the ground fault site determination unit 123 in the control circuit 105. The ground fault site determination unit 123 receives the current ratio Imin/Imax and the phase number SP of the ground fault from the current ratio calculation unit 121, and an inductance Lc of the motor cable and the inductance value Lm of the internal motor winding from the inductance value storage unit 122. The ground fault site determination unit 123 determines the ground fault on a cable when the current ratio Imin/Imax is smaller than Lc/(Lc + 3Lm), and the ground fault in the motor when the current ratio Imin/Imax is larger than Lc/ (Lc + 3Lm) on the basis of Expression 4. Further, the ground fault site determination unit determines the ground fault in detail on the basis of the values of Imin/Imax. The ground fault on a cable near the inverter is determined when the value is smaller than Lc/ (Lc + 3Lm) and close to "0". The ground fault on a cable near a terminal in the motor is determined when the value is larger than Lc/ (Lc + 3Lm) and close thereto. The ground fault of the internal winding near the neutral point in the motor is determined when the value is close to "1". Further, with the value representing the ground fault site on a cable (Len_s/Len_c = Imin/Imax ÷ (Lc/(Lc + 3Lm))*100), it is determined whether there is a ground fault site at a point indicating how many percentages are progressed from the converter to the motor. The ground fault site determination unit 123 transmits the determination result and the phase number SP of the ground fault to the display device 108 and the transmitter 109.

"Lc" and "Lm" stored in the inductance value storage unit are input in advance by the input device 106 or the receiver 107. Instead of inputting the inductance value Lc of the motor cable, a cable length Len and a cable type of the using motor cable may be input, and the inductance value Lm may be calculated from the cable length Len using a proportion coefficient in accordance with the cable type. In addition, instead of inputting the inductance value Lm of the internal winding of the motor, the inductance value Lm + Lc may be acquired by an auto-tuning operation at the time of normally driving the motor, and "Lc" is subtracted therefrom to obtain the inductance value Lm.

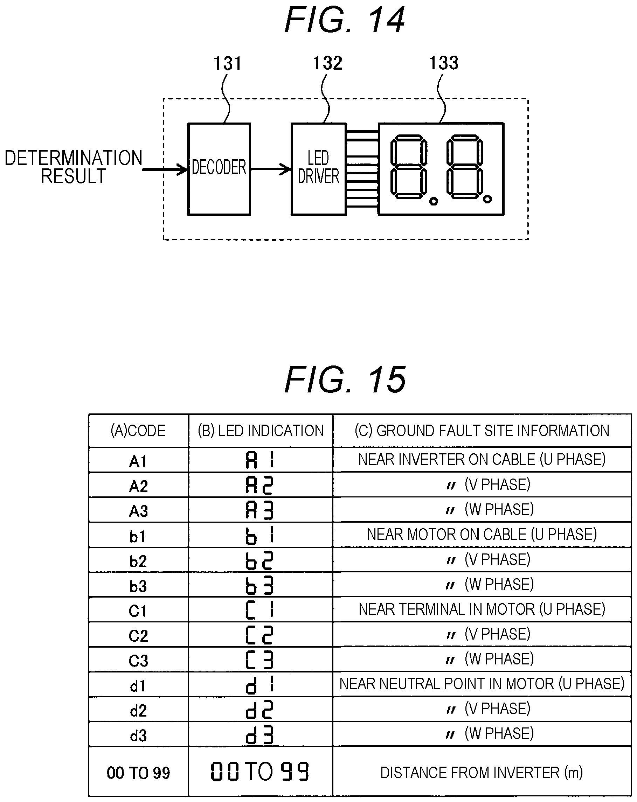

FIG. 14 illustrates a diagram illustrating a configuration of the display device 108. The display device 108 is configured by a decoder 131, an LED driver 132, and a 2-digit LED segment 133. The determination result of the ground fault and the phase number of the ground fault which are sent from the control circuit 105 are decoded into a display pattern of numbers and characters of the LED segment by the decoder 131. The LED 132 driver causes the LED segment 133 to display the decoded display pattern according to a current signal.

FIG. 15 illustrates a table of a correspondence relation between the display pattern displayed in the LED segment 133 and the ground fault site. (B) display patterns are obtained by expressing (A) codes using a 7-segment LED. Codes A1 to A3 mean that the ground fault site is close to the inverter of the motor cable. Codes b1 to b3 mean that the ground fault site is close to the motor of the motor cable. Codes C1 to C3 mean that the ground fault site is close to the terminal on the motor winding. Codes d1 to d3 mean that the ground fault site is close to the neutral point on the motor winding. In addition, numerical values 00 to 99 mean a distance from the inverter at the ground fault site on the motor cable. The table illustrating a correspondence relation of FIG. 15 may be posted in a manual of the power conversion device or the side surface of the power conversion device in order for the user to easily understand the correspondence between the codes and the ground fault information.

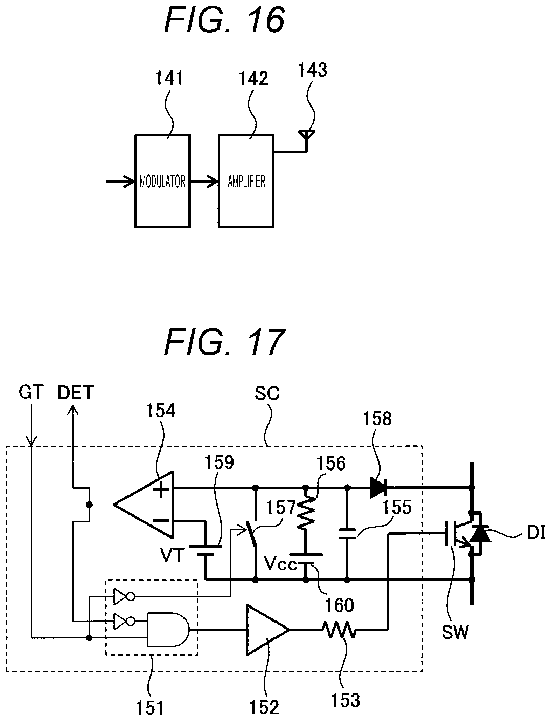

FIG. 16 illustrates a diagram illustrating a configuration of a transmitter 109. The transmitter 109 is configured by a modulator 141, an amplifier 142, and an antenna 143. The determination result of the ground fault and the short-circuit phase number sent from the control circuit 105 are modulated by the modulator 141, amplified by the amplifier 142, and wirelessly transmitted to the outside by the antenna 143. While not illustrated in the drawing, another device and system receive and demodulate the wirelessly transmitted signal to obtain information of the determination result of the ground fault and the phase number of the ground fault. In addition, a tablet terminal is used such that an application software embedded with the table illustrating the correspondence relation of FIG. 15 is installed in the tablet terminal, and can display the ground fault information in a screen of the tablet terminal.

FIG. 17 illustrates a diagram illustrating a configuration of the switch drive circuits SDu, SDv, SDw, SDx, SDy, and SDz. The switch drive circuit is configured by a logical circuit 151, a gate drive amplifier 152, a gate resistor 153, a comparator 154, a capacitor 155, a capacitor charging resistor 156, a capacitor discharging switch 157, a diode 158, and constant-voltage sources 159 and 160. The gate drive amplifier 152 and the gate resistor 153 are used to control ON/OFF of the switch SW for the connection. In a case where a gate signal GT from the control circuit 105 is "1", the gate drive amplifier 152 outputs a gate-ON voltage to turn ON the switch SW. In a case where the gate signal GT is "0", the gate drive amplifier 152 outputs a gate-OFF voltage to turn OFF the switch SW. The gate resistor 153 controls a switching speed. On the other hand, the comparator 154, the capacitor 155, the capacitor charging resistor 156, the capacitor discharging switch 157, the diode 158, and the constant-voltage sources 159 and 160 form an overcurrent detection circuit. The overcurrent detection circuit is a circuit of a desaturation detection scheme. The constant-voltage source 159 is a voltage source of an overcurrent threshold voltage VT, and the constant-voltage source 160 is a voltage source of a voltage Vcc higher than the voltage VT. The overcurrent threshold VT is a value determined from a collector voltage when the current flowing in the switch becomes an overcurrent threshold ITH. In the OFF state of the switch SW, the capacitor discharging switch 157 is turned ON, so that the output of the comparator is "0". In addition, in a case where the overcurrent does not occur in the ON state of the switch SW, the collector voltage of the switch SW (IGBT) is sufficiently low, and the capacitor 155 is discharged through the diode 158, so that the output of the comparator is "0". However, in a case where the overcurrent occurs in the ON state of the switch SW, the collector voltage of the switch SW (IGBT) becomes higher than the threshold voltage VT, and the capacitor 155 is not discharged. When the capacitor 155 is charged by the discharging current of the capacitor charging resistor 156 and the potential of the capacitor exceeds the threshold voltage VT, the comparator 154 outputs "1", and the switch is forcibly blocked by the logical circuit 151. In addition, notification of the short circuit is provided to the control circuit 105 as a short-circuit detection signal DET. As described above, the switch drive circuit illustrated in FIG. 17 serves as a gate driver circuit equipped with an overcurrent protection function, and notifies the control circuit 105 of the short circuit immediately after the short-circuit occurs. Further, the six switches, the diodes, and a switch control circuit of the inverter circuit 104 are configured equally, and thus the components will be attached with suffixes u, v, w, x, y, and z after the symbols SW, DI, and SD, and the descriptions thereof will be omitted.

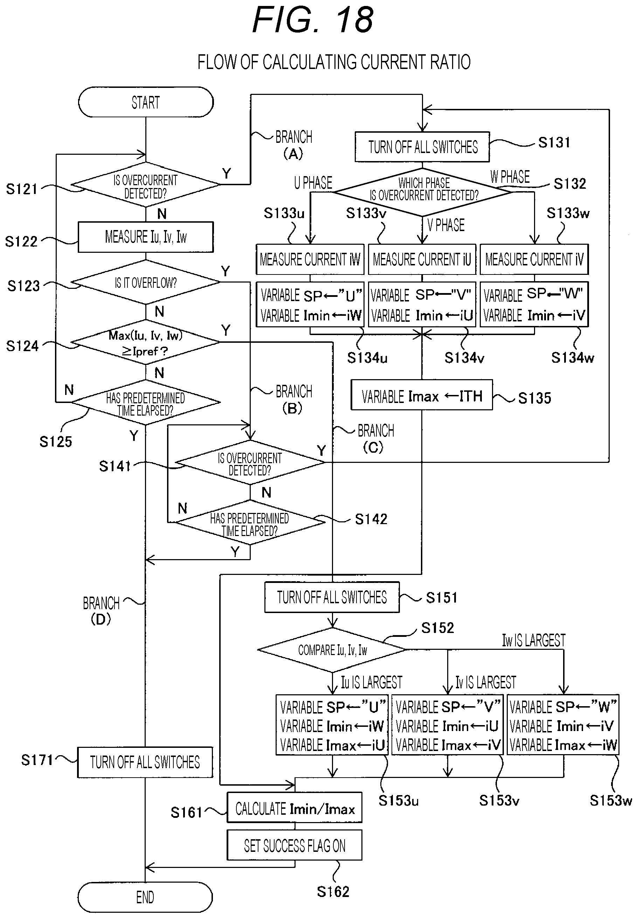

FIG. 18 illustrates a flowchart of the current ratio calculations S112 and S115. The control circuit 105 inspects the current amount on the basis of the current value of the current sensor and the overcurrent detection signal in the processes S121 to S125, and branches to (A), (B), (C), and (D) . In a case where the overcurrent detection signal from any one switch drive circuit SD is received, the procedure branches to (A) (S121) . The current of each phase is measured by the current measurement circuit 111 (S122). Then, in a case where the measured current falls out of the measurement range, and overflowed, the procedure branches to (B) (S123). In a case where the maximum current value among the measured currents of the three phases reaches the current value Ipref suitable for the measurement range of the current sensor, the procedure branches to (C) (S124) . In a case where the maximum value does not reach the suitable current value Ipref even after a predetermined time elapses, the procedure branches to (D) (S125).

In a case where the procedure branches to (A), the process of the phase from which the overcurrent is detected branches to three depending on U, V, and W (S132) . In a case where the overcurrent is detected at the U phase, the U phase is the maximum current phase (that is, the ground fault phase). Therefore, "U" is input to the variable SP indicating the ground fault phase. The current measurement value Iw of the non-ground-fault phase is input to the variable Imin (S133u, S134u) . In a case where the overcurrent is detected at the V phase, the V phase is the maximum current phase (that is, the ground fault phase). Therefore, "V" is input to the variable SP indicating the ground fault phase. The current measurement value Iu of the non-ground-fault phase is input to the variable Imin (S133v, S134v) . In a case where the overcurrent is detected at the W phase, the W phase is the maximum current phase (that is, the ground fault phase). Therefore, "W" is input to the variable SP indicating the ground fault phase. The current measurement value Iv of the non-ground-fault phase is input to the variable Imin (S133w, S134w). Even in any case, the threshold ITH of the overcurrent protection circuit is input to the variable Imax (S135).

In a case where the procedure branches to (B), the procedure is on standby until the overcurrent is detected (S141, S142). At the time when the overcurrent is detected, the procedure proceeds to the same processes S131 to S135 as those of (A) .

In a case where the procedure branches to (C), the current measurement values Iu, Iv, and Iw in the process S122 are compared to branch to three (S152). In a case where "Iu" is a maximum value, the U phase is the ground fault phase. Therefore, "U" is input to the variable SP indicating the ground fault phase, "Iu" is input to the variable Imax, and "Iw" is input to the variable Imin (S153u). In a case where "Iv" is a maximum value, the V phase is the ground fault phase. Therefore, "V" is input to the variable SP indicating the ground fault phase, "Iv" is input to the variable Imax, and "Iu" is input to the variable Imin (S153v). In a case where "Iw" is a maximum value, the W phase is the ground fault phase. Therefore, "W" is input to the variable SP indicating the ground fault phase, "Iw" is input to the variable Imax, and "Iv" is input to the variable Imin (S153w).

After the processes of (A), (B), and (C) are normally ended, finally the current ratio Imin/Imax is calculated, and a success flag is set ON and the procedure ends (S161, S162) . In a case where the procedure branches to (D), the success flag is not set ON and the procedure ends.

Further, all the switches in all the processes of (A), (B), (C), and (D) are turned OFF until the flow ends (S131, S151, and S171).

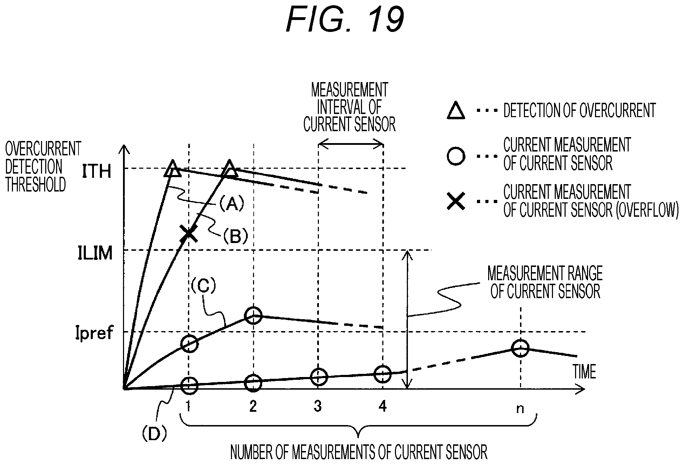

FIG. 19 illustrates an example of short-circuit current waveforms having different current increasing speeds. The increasing speed of the current becomes fast in a case where the voltage to ground Vtrn is high or in a case where the inductance of the current path is small. On the contrary, the increasing speed of the current becomes delayed in a case where the voltage to ground Vtrn is low or a case where the inductance of the current path is large.

The horizontal axis represents time, and the numbers represent the number of times of measurement of the current sensor. In general, a measurement period of the current sensor is determined, and thus it is hard to repeatedly perform the measurement faster than the period. On the other hand, the overcurrent protection circuit is configured by a comparator, and thus the overcurrent detection can be made at a μs-order speed. The vertical axis represents the current value illustrating the current threshold ITH of the overcurrent protection circuit, a measurement upper limit ILIM of the current sensor, and the suitable current value Ipref from the upper side.

The current waveform (A) indicates a current waveform in a case where the current reaches the threshold ITH of the overcurrent protection circuit in a period of time shorter than the measurement period of the current sensor. Since the overcurrent protection circuit detects the overcurrent before a first current measurement comes to be made, the current measurement can be successful by proceeding to (A) in the process of the flowchart illustrated in FIG. 18.

The current waveform (B) indicates a current waveform in a case where the first current measurement is overflowed. Since the current is already overflowed, the current measurement is not possible in the current sensor. In this case, the current measurement can be successful by proceeding to (B) in the process of the flowchart illustrated in FIG. 18.

The current waveform (C) indicates a current waveform in a case where the current can be measured by the current sensor. In this case, the current measurement can be successful by proceeding to (C) in the process of the flowchart illustrated in FIG. 18.

The current waveform (D) indicates a current waveform in a case where the current can be measured by the current sensor, the increasing speed of the current is delayed, and the current does not reach the current value Ipref more suitable with respect to the measurement range of the current sensor in a predetermined time. In this case, the procedure ends without performing the current measurement by proceeding to (D) in the process of the flowchart illustrated in FIG. 18.

As described above, when the current increases faster than the measurement period of the current sensor, the current value can be measured by using the detection signal of the overcurrent detection circuit.

[Second embodiment]

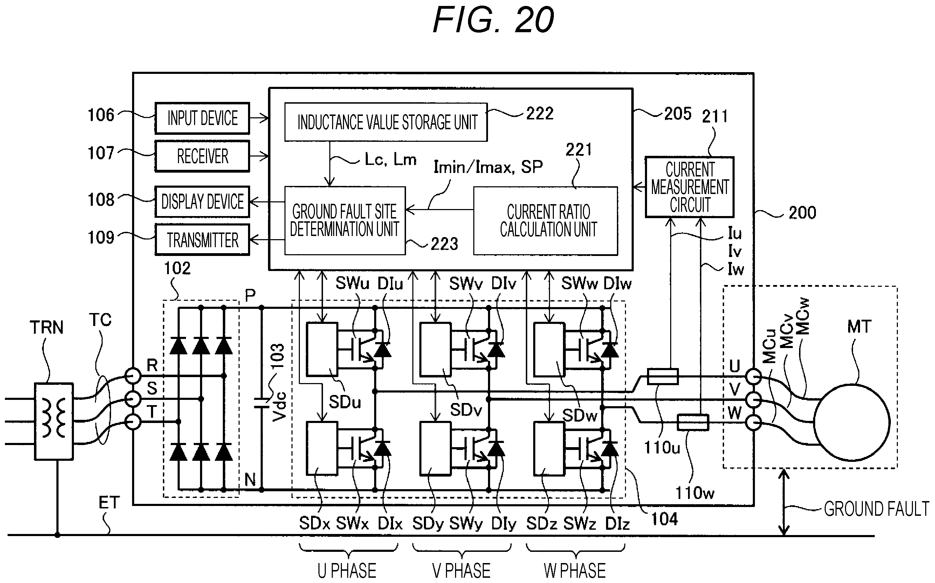

FIG. 20 illustrates a diagram illustrating a configuration of a second embodiment of the power conversion device of the invention. The same components as those of the first embodiment will be attached with the same symbols, and the description thereof will be omitted. A power conversion device 200 includes, between the inverter circuit 104 and the output terminals U and W, two current sensors 110u and 110w to measure the output current values of two phases and a current measurement circuit 211 to measure these measurement values. The current sensors 110u and 110w measure the current values Iu and Iw which are output from the output terminals U and W, and transfer the current values as analog voltages or currents to the current measurement circuit 211. The current measurement circuit 211 samples the analog information, digitizes the information, and transmits the digital data to a control circuit 205.

The control circuit 205 includes a current ratio calculation unit 221, the inductance value storage unit 222, and a ground fault site determination unit 223. The power ratio calculation unit 221 transmits, to the ground fault site determination unit 223, the phase number SP of the maximum current phase and the current ratio Imin/Imax of the current Imax of the maximum current phase and the current Imin of the minimum current phase on the basis of the current value data sent from the current measurement circuit 211 and the short-circuit detection signal from each switch drive circuit. The ground fault site determination unit estimates the ground fault site on the basis of the information SP and the ratio Imin/Imax transmitted from the current ratio calculation unit, and the inductance value Lc of the motor cable MC and the inductance value Lm of the internal motor winding which are stored in the inductance value storage unit 223. The determination result is transmitted to the display device 108 and the transmitter 109.

Similarly to the power conversion device of the first embodiment, the power conversion device of the second embodiment of the invention determines the ground fault site by the determination flow of the site of the ground fault illustrated in FIG. 2 and the processing flow of the ground fault current inspection illustrated in FIG. 3. However, the power conversion device of the second embodiment has a different current ratio calculation flow because there are only two current sensors 110u and 110w.

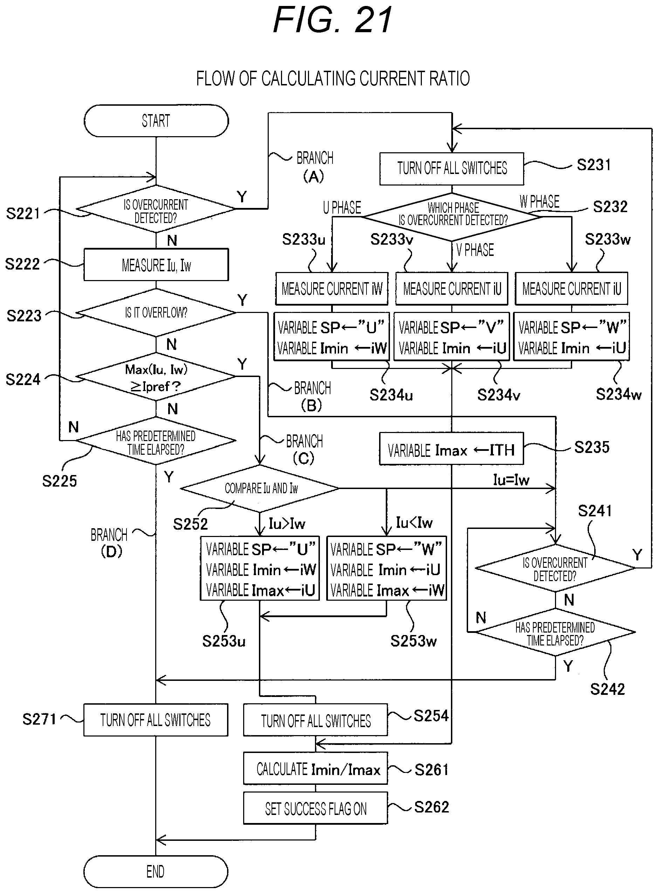

FIG. 21 illustrates a flowchart of the current ratio calculation which is used in the second embodiment of the invention. The control circuit 205 inspects the current amount on the basis of the current value of the current sensor and the overcurrent detection signal in the processes of S221 to S225, and branches to (A), (B), (C), and (D). In a case where the overcurrent detection signal from any one switch drive circuit SD is received, the procedure branches to (A) (S221). The currents Iu and Iw of the U and W phases are measured by the current measurement circuit 211 (S222). Then, in a case where the measured current falls out of the measurement range, and overflowed, the procedure branches to (B) (S223). In a case where the maximum current value among the measured currents of the two phases reaches the current value Ipref suitable for the measurement range of the current sensor, the procedure branches to (C) (S224). In a case where the maximum value does not reach the suitable current value Ipref even after a predetermined time elapses, the procedure branches to (D) (S225).

In a case where the procedure branches to (A), the process of the phase from which the overcurrent is detected branches to three depending on U, V, and W (S232). In a case where the overcurrent is detected at the U phase, the U phase is the maximum current phase (that is, the ground fault phase). Therefore, "U" is input to the variable SP indicating the ground fault phase. The current measurement value Iw of the non-ground-fault phase is input to the variable Imin (S233u, S234u). In a case where the overcurrent is detected at the V phase, the V phase is the maximum current phase (that is, the ground fault phase). Therefore, "V" is input to the variable SP indicating the ground fault phase. The current measurement value Iu of the non-ground-fault phase is input to the variable Imin (S233v, S234v). In a case where the overcurrent is detected at the W phase, the W phase is the maximum current phase (that is, the ground fault phase). Therefore, "W" is input to the variable SP indicating the ground fault phase. The current measurement value Iu of the non-ground-fault phase is input to the variable Imin (S233w, S234w). Even in any case, the threshold ITH of the overcurrent protection circuit is input to the variable Imax (S135).

In a case where the procedure branches to (B), the procedure is on standby until the overcurrent is detected (S241, S242). At the time when the overcurrent is detected, the procedure proceeds to the same processes S231 to S235 as those of (A).

In a case where the procedure branches to (C), the current measurement values Iu and Iw in the process S222 are compared to branch to three (S252). In a case where "Iu" is obviously larger than "Iw", the U phase is the ground fault phase. Therefore, "U" is input to the variable SP indicating the ground fault phase, "Iu" is input to the variable Imax, and "Iw" is input to the variable Imin (S253u). In a case where "Iw" is obviously larger than "Iu", the W phase is the ground fault phase. Therefore, "W" is input to the variable SP indicating the ground fault phase, "Iw" is input to the variable Imax, and "Iu" is input to the variable Imin (S253w). In a case where "Iu" is almost the same degree as "Iw", the V phase is the ground fault phase. However, since there is no current sensor in the V phase, the process is on standby until the current of the V phase is detected as the overcurrent by the overcurrent detection circuit. The current ratio can be acquired by performing the process of acquiring "Iu" and "Iw" again when the current of the V phase reaches the threshold ITH. Therefore, in a case where "Iu" is almost the same degree as "Iw", the process joins to (B) and proceeds to the processes (S241, S242) of being on standby until the overcurrent is detected. At the time when the overcurrent is detected, the procedure proceeds to the same processes S231 to S235 as those of (A).

After the processes of (A), (B), and (C) are normally ended, finally the current ratio Imin/Imax is calculated, and a success flag is set ON and the procedure ends (S261, S262). In a case where the procedure branches to (D), the success flag is not set ON and the procedure ends. Further, all the switches in all the processes of (A), (B), (C), and (D) are turned OFF until the flow ends (S231, S254, and S271).

With the current ratio calculation flow described above, it is possible to obtain a current ratio Imax/Imin only by the current values Iu and Iw measured by the current sensors 110u and 110w without using the current value Iv of the V phase.

[Other determination flow of ground fault site]

The power conversion device of the second embodiment of the invention can determine the ground fault site by a flow of determining the site of the ground fault which is different from that of FIG. 2.

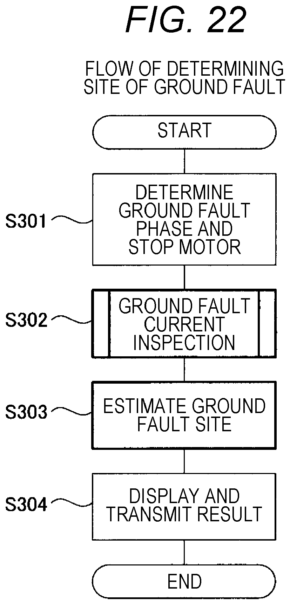

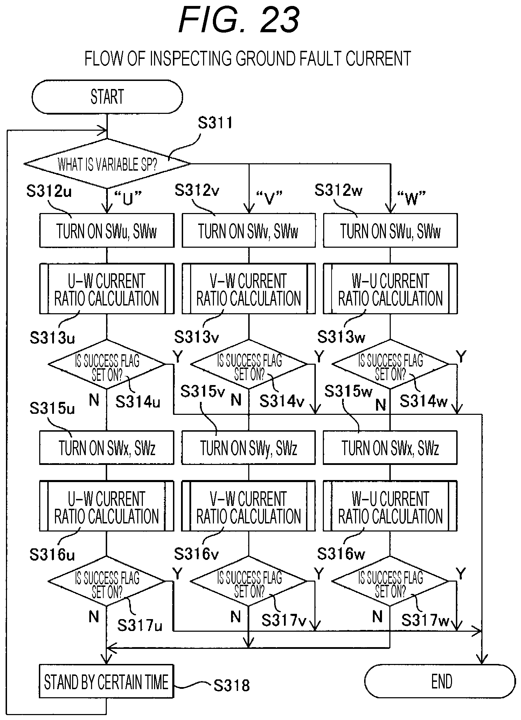

FIG. 22 illustrates another flowchart of determining the site of the ground fault in the second embodiment of the invention. The flow of FIG. 22 starts with the overcurrent detection signal by the protection circuit in accordance with the ground fault occurrence. The control circuit 205 determines that a certain phase of the protection circuit generating the detection signal, and stores any one of "U", "V", and "W" (the phase number of the ground fault information) as the variable SP in the current ratio calculation unit 221. Thereafter, the control circuit 205 performs a motor stop action (S301). Specifically, all the switches of the converter circuit 104 are turned OFF to stop the power supply to the motor, and are on standby until the current value of all phases calculated by the current measurement circuit 211 becomes "0". After the motor is stopped, the control circuit 205 performs the ground fault current inspection. The current ratio calculation unit 221 outputs the current ratio Imin/Imax and the maximum current phase (S302). Herein, the flow of the ground fault current inspection illustrated in FIG. 23 is performed. Thereafter, the ground fault site is determined on the basis of these pieces of information, and the inductance value Lc of the motor cable MC and the inductance value Lm of the internal motor winding stored in the inductance value storage unit 223 (S303). The determination result is transmitted to the display device 108 and the transmitter 109 (S304).

FIG. 23 illustrates a flowchart of the ground fault current inspection performed in FIG. 22. The process of the control circuit 205 first branches to three according to the phase number of the variable SP (S311). In a case where the phase number of the variable SP is "U" in the branch of the process S311, the control circuit 205 turns ON of all the switches SWu and SWw of the upper arm (S312u). Thereafter, the current ratio Imin/Imax is calculated on the basis of the current value measured by the current measurement circuit 211 and the detection signal of the overcurrent protection circuit. In a case where the current sufficient for the calculation can be measured, and the calculation of the current ratio is successful, the flow ends (S313u, S314u). In a case where the current sufficient for a U-W current ratio calculation S313u is not measured, all the switches are once turned OFF. Then, the switches SWx and SWz of the lower arm are turned ON (S315u). Thereafter, the current ratio Imin/Imax is calculated on the basis of the current value measured by the current measurement circuit 211 and the detection signal of the overcurrent protection circuit. In a case where the current sufficient for the calculation can be measured, and the calculation of the current ratio is successful, the flow ends (S316u, S317u). In a case where the phase number of the variable SP is "V" in the branch of the process S311, the control circuit 205 turns ON all the switches SWv and SWw of the upper arm (S312v). Thereafter, the current ratio Imin/Imax is calculated on the basis of the current value measured by the current measurement circuit 211 and the detection signal of the overcurrent protection circuit. In a case where the current is measured sufficient to the calculation, and the calculation of the current ratio is successful, the flow ends (S313v, S314v). In a case where the current sufficient for a V-W current ratio calculation S313v is not measured, all the switches are once turned OFF. Then, the switches SWy and SWz of the lower arm are turned ON (S315v). Thereafter, the current ratio Imin/Imax is calculated on the basis of the current value measured by the current measurement circuit 211 and the detection signal of the overcurrent protection circuit. In a case where the current is measured sufficient to the calculation, and the calculation of the current ratio is successful, the flow ends (S316v, S317v). In a case where the phase number of the variable SP is "W" in the branch of the process S311, the control circuit 205 turns ON all the switches SWu and SWw of the upper arm (S312w). Thereafter, the current ratio Imin/Imax is calculated on the basis of the current value measured by the current measurement circuit 211 and the detection signal of the overcurrent protection circuit. In a case where the current is measured sufficient to the calculation, and the calculation of the current ratio is successful, the flow ends (S313w, S314w). In a case where the current sufficient for a W-U current ratio calculation S313w is not measured, all the switches are once turned OFF. Then, the switches SWx and SWz of the lower arm are turned ON (S315w). Thereafter, the current ratio Imin/Imax is calculated on the basis of the current value measured by the current measurement circuit 211 and the detection signal of the overcurrent protection circuit. In a case where the current is measured sufficient to the calculation, and the calculation of the current ratio is successful, the flow ends (S316w, S317w) . In a case where the current sufficient for a U-W current ratio calculation S316u, a V-W current ratio calculation S316v, and a W-U current ratio calculation S316w is not measured, the process is on standby for a certain period of time (S318). Thereafter, the flow restarts from the first step.

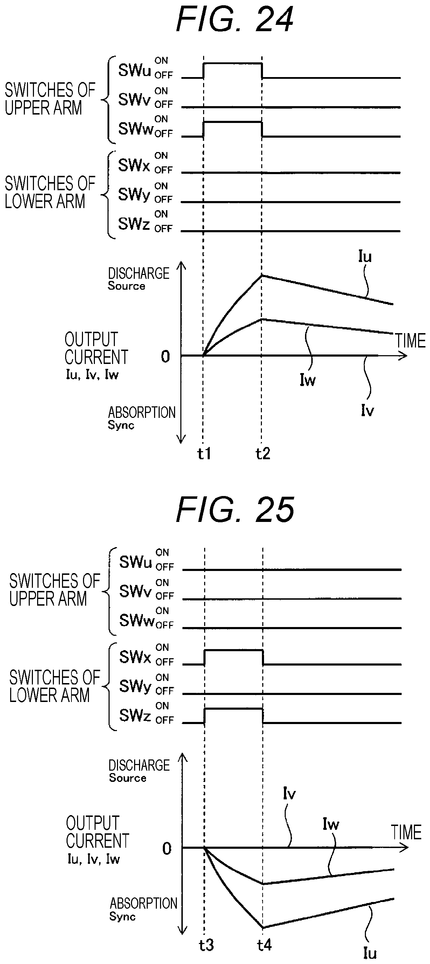

FIG. 24 illustrates states of the switches at the current ratio calculation S313u and before and after the calculation, and output current waveforms. When the switches SWu and SWw of the upper arm are turned ON at time t1, the discharge current is generated at the outputs of the U and W phases. While the current is increased as time goes by, the current of the U phase having the ground fault is increased steeply more than the current of the W phase having no ground fault. As a result, the current of the U phase having the ground fault is kept higher than the current of the W phase having no ground fault. This state is kept until all the switches are turned OFF at time t2.

FIG. 25 illustrates states of the switches at the current ratio calculation S316u and before and after the calculation, and an example of output current waveforms. When the switches SWx and SWz of the lower arm are turned ON at time t3, the absorption current is generated at the outputs of the U and W phases. While the current is increased as time goes by, the current of the U phase having the ground fault is increased steeply more than the current of the W phase having no ground fault. As a result, the current of the U phase having the ground fault is kept higher than the current of the W phase having no ground fault. This state is kept until all the switches are turned OFF at time t4.

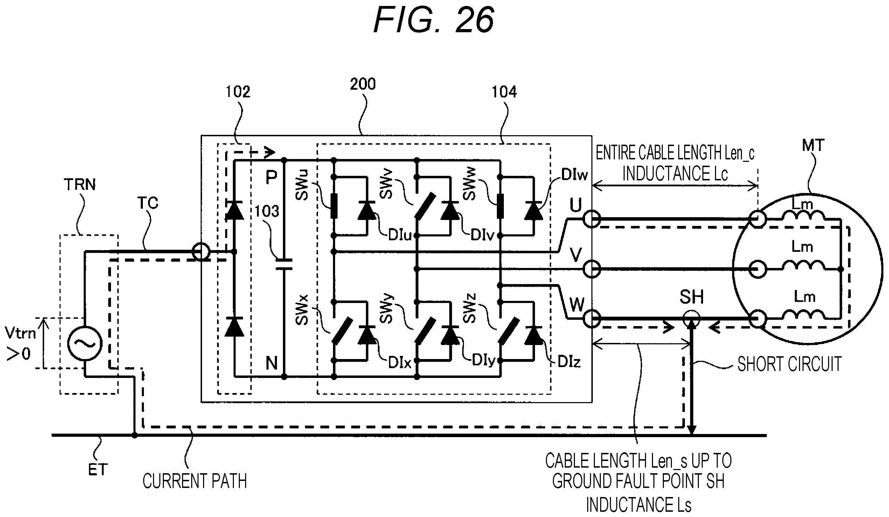

FIG. 26 illustrates an example of the current path of the current between time t1 and time t2 illustrated in FIG. 24. In FIG. 26, there is illustrated a situation where the ground fault occurs on the motor cable (ground fault point SH) of W-phase as an example. An electromotive force causing the current is a voltage to ground Vtrn of the output (secondary side) of the transformer. While the output of the transformer is a three-phase output, the current flows in from the phase having the positive voltage to ground Vtrn by the diodes of the converter circuit 102. In a case where there are plural phases having the positive voltage to ground Vtrn, the current flows in from the plural phases. However, for the sake of simplicity in the explanation, only one phase set of the transformer TRN, the power cable TC, and the diodes of the converter circuit 102 is illustrated in FIG. 26. The current, which is supplied from the transformer TRN and flows into through the diodes of the converter circuit 102, passes through the turned-ON two switches SWu and SWw of the upper arm in the inverter circuit 104 via Node P, and are divided into two currents. The divided currents are joined at the ground fault point SH through the output terminals U and W. The joined current flows in the earth ET and returns to the transformer TRN.

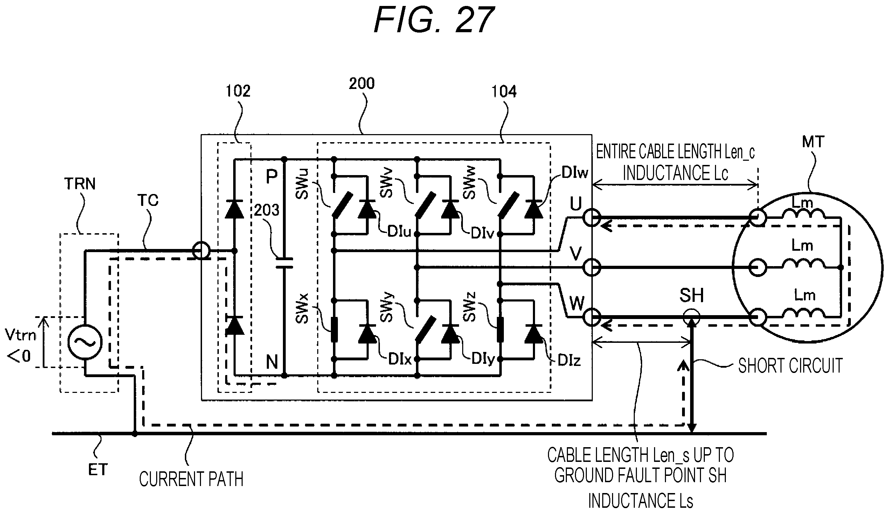

FIG. 27 illustrates an example of the current path of the current between time t3 and t4 illustrated in FIG. 25. In FIG. 27, there is illustrated a situation where the ground fault occurs on the motor cable of W-phase (the ground fault point SH) as an example. An electromotive force causing the current is a voltage to ground Vtrn of the output (secondary side) of the transformer. While the output of the transformer is a three-phase output, the current flows in from the converter circuit 102 to the phase having the negative voltage to ground of the transformer TRN by the diodes of the converter circuit 102. In a case where there are plural phases having the negative voltage to ground, the current flows to the plural phases. However, for the sake of simplicity in the explanation, only one phase set of the transformer TRN, the power cable TC, and the diodes of the converter circuit 102 is illustrated in FIG. 27. The current output from the transformer TRN flows in the earth ET and reaches the ground fault point SH, and is divided into two to flow to the output terminals U and W. The divided currents flow in the turned-ON two switches SWx and SWz of the lower arm in the inverter circuit 104, are joined at Node N, and return to the converter circuit 102.

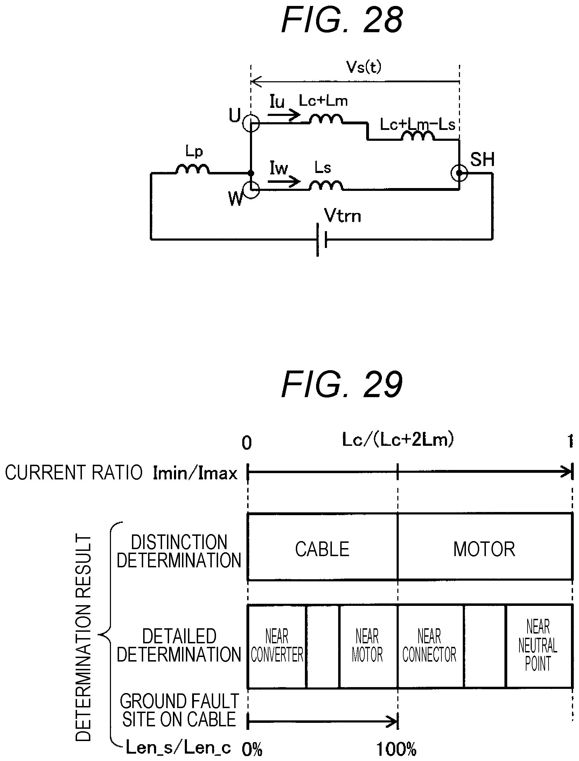

FIG. 28 illustrates an equivalent circuit of the current path illustrated in FIG. 26. "Vtrn" represents a potential to ground of the output of the transformer TRN, and "Lp" represents a series inductance (a sum of the inductances) of the inductances of the earth ET, the transformer TRN, and the power cable TC. "Lc" and "Lm" represent an inductance of the motor cable and the inductance of the internal motor winding respectively as illustrated in FIG. 26. Further, "Ls" represents an inductance up to the output terminal W and a ground fault site SH as illustrated in FIG. 6. "Iw" representing a short-circuit phase is described in Expression 5.

$$Iw = \int Vs(t)dt/Ls \quad \text{(Expression 5)}$$

Herein, Vs (t) represents voltages between the terminals U and W and the ground fault point SH. On the other hand, "Iu" and "Iv" representing a non-short-circuit phase are described in Expression 6.

$$Iu = \int Vs(t)dt/(2Lc + 2Lm - Ls) \quad \text{(Expression 6)}$$

The current ratio of the short-circuit phase and the non-short-circuit phase is obtained as Expression 7, and becomes a constant value regardless of time t.

$$\mathrm{Iu/Iw\ =\ Ls/(2Lc\ +\ 2Lm\ -\ Ls)} \qquad \text{(Expression 7)}$$

Herein, in a case where the ground fault occurs on the cable, Ls < Lc is satisfied, so that Iu/Iw < 1 (that is, Iu < Iw) is satisfied, and the current of the ground fault phase always becomes larger than the current of the non-ground-fault phase. Therefore, if the inspection is made on a phase having the largest current among the three phases, it can be seen that the largest current flows to the ground fault phase.

In a case where the ground fault point SH is at the end of the motor cable, Ls = Lc is satisfied. At this time, the current ratio is obtained as Expression 8.

$$\mathrm{Iu/Iw\ =\ Iv/Iw\ =\ Lc/(Lc\ +\ 2Lm)} \qquad \text{(Expression 8)}$$

Even in this case, Iu/Iw < 1 (that is, Iu < Iw) is satisfied, and the current of the ground fault phase always becomes larger than the current of the non-ground-fault phase. In addition, FIG. 26 illustrates that the ground fault point SH is on the cable, but it can be said that there is no difference even when the ground fault point is on the internal winding of the motor. In a case where the ground fault point SH is on the internal winding of the motor, Lc < Ls < Lc + Lm is satisfied. Even in the condition of "Lc", Iu/Iw < 1 (that is, Iu < Iw) is satisfied, and the current of the ground fault phase always becomes larger than the current of the non-ground-fault phase. In addition, an equivalent circuit of the current path illustrated in FIG. 27 is also equal to that in FIG. 28. Even though the directions of the currents Iu and Iw are opposite, there is no difference from the above description as a result.

While the above description on FIGS. 26 to 28 has been give about the current ratio calculations S313u and S316u, the same operation principle is applied even to the current ratio calculations S313v, S316v, S313w, and S316w in which only the phase where the switch is turned ON and the phase where the current flows are different. As a result, it can be said that the operations are the same as those of the above description.

FIG. 29 illustrates a determination method used by the ground fault site determination unit 223 in the control circuit 205. The ground fault site determination unit 223 receives the current ratio Imin/Imax and the phase number SP of the ground fault from the current ratio calculation unit 221, and an inductance Lc of the motor cable and the inductance value Lm of the internal motor winding from the inductance value storage unit 222. The ground fault site determination unit 223 determines the ground fault on a cable when the current ratio Imin/Imax is smaller than Lc/(Lc + 2Lm), and the ground fault in the motor when the current ratio Imin/Imax is larger than Lc/(Lc + 2Lm) on the basis of Expression 8. Further, the ground fault site determination unit determines the ground fault in detail on the basis of the values of Imin/Imax. The ground fault on a cable near the inverter is determined when the value is smaller than Lc/(Lc + 2Lm) and close to "0". The ground fault on a cable near a terminal in the motor is determined when the value is larger than Lc/(Lc + 2Lm) and close thereto. The ground fault of the internal winding near the neutral point in the motor is determined when the value is close to "1". Further, with the value representing the ground fault site on a cable (Len_s/Len_c = Imin/Imax ÷ (Lc/(Lc + 2Lm))*100), it is determined whether there is a ground fault site at a point indicating how many percentages are progressed from the converter to the motor. The ground fault site determination unit 223 transmits the determination result and the phase number SP of the ground fault to the display device 108 and the transmitter 109.

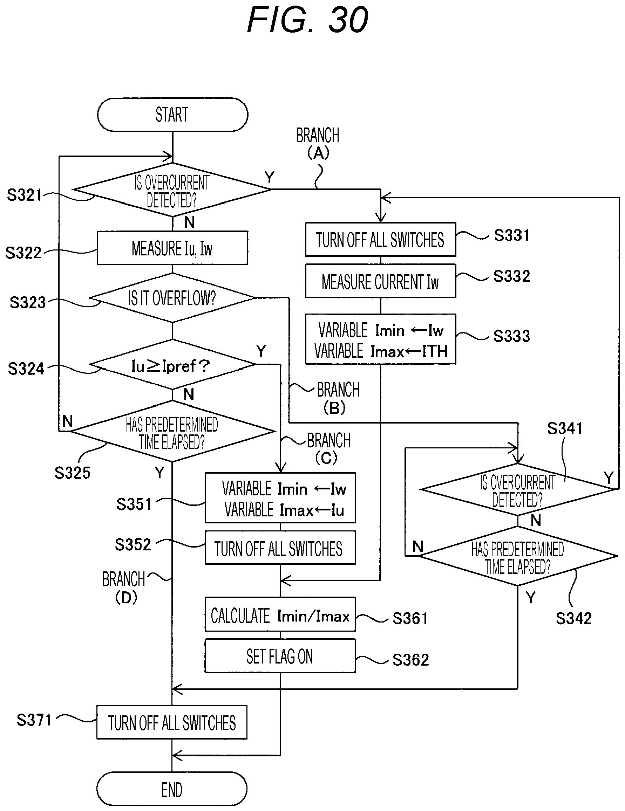

FIG. 30 illustrates a flowchart of the U-W current ratio calculations S313u and S316u illustrated in FIG. 23. The control circuit 205 inspects the current amount on the basis of the current value of the current sensor and the overcurrent detection signal in the processes S321 to S325, and branches to (A), (B), (C), and (D). In a case where the overcurrent detection signal from the switch drive circuit SD of the U phase is received, the procedure branches to (A) (S321). The currents Iu and Iw of the U and W phases are measured by the current measurement circuit 211 (S322). Then, in a case where the measured current falls out of the measurement range, and overflowed, the procedure branches to (B) (S323). In a case where the measured current value Iu reaches the current value Ipref suitable for the measurement range of the current sensor, the procedure branches to (C) (S324). In a case where the maximum value does not reach the suitable current value Ipref even after a predetermined time elapses, the procedure branches to (D) (S325). In a case where the procedure branches to (A), the current measurement value Iw of the non-ground-fault phase is input to the variable Imin, and the threshold ITH of the overcurrent protection circuit is input to the variable Imax (S332, S333). In a case where the procedure branches to (B), the procedure is on standby until the overcurrent is detected (S341, S342). At the time when the overcurrent is detected, the procedure proceeds to the same processes S331 to S333 as those of (A). In a case where the procedure branches to (C), the current value Iw measured in the process S322 is substituted to the variable Imin, and the current value Iu is substituted to the variable Imax (S351). After the processes of (A), (B), and (C) are normally ended, finally the current ratio Imin/Imax is calculated, and a success flag is set ON and the process ends (S361, S362). In a case where the procedure branches to (D), the success flag is not set ON and the procedure ends. Further, all the switches in all the processes of (A), (B), (C), and (D) are turned OFF until the flow ends (S331, S352, and S371).

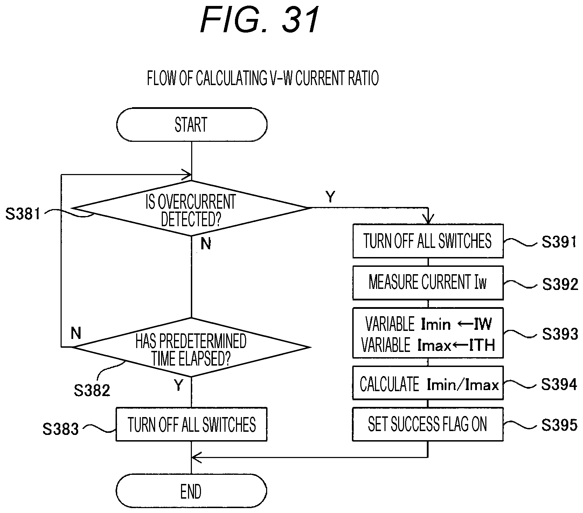

The flowchart of the W-U current ratio calculations S313w and S316w illustrated in FIG. 23 is a flowchart where the U phase of the flowchart of FIG. 30 is replaced with the W phase (that is, the currents Iu and Iw are replaced with each other). FIG. 31 illustrates a flowchart of the V-W current ratio calculations S313v and S316v illustrated in FIG. 23. However, since there is no current sensor in the V phase, in the flowchart of FIG. 31, the process is on standby until the current of the V phase is detected as the overcurrent by the overcurrent detection circuit. The current ratio can be acquired by measuring "Iv" when the current of the V phase reaches the threshold ITH. In a case where the overcurrent is detected by the overcurrent detection circuit of the V phase, the control circuit 205 measures the current value Iw right away, and substitutes the current value to the variable Imin. The threshold ITH of the overcurrent protection circuit is input to the variable Imax (S392, S393). Then, the current ratio Imin/Imax is calculated, and the success flag is set ON and the process ends (S394, S395). In addition, in a case where the overcurrent is not detected even after a predetermined time elapses, the process ends. In addition, all the switches are turned OFF until the flow ends (S383, S391).

With the current ratio calculation flow described above and illustrated in FIGS. 30 and 31, it is possible to obtain a current ratio Imax/Imin only by the current values Iu and Iw measured by the current sensors 110u and 110w without using the current value Iv of the V phase.

[Third embodiment]

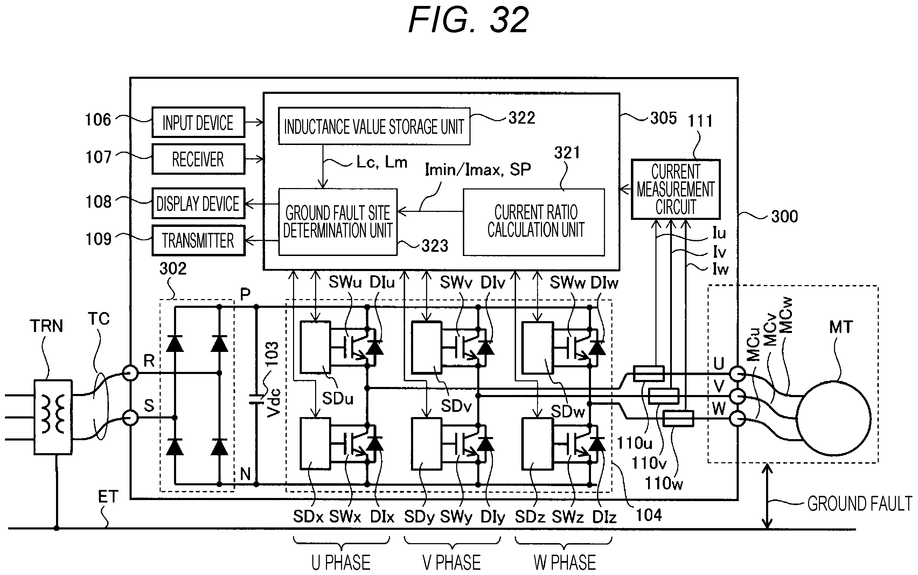

FIG. 32 illustrates a configuration of a third embodiment of the power conversion device of the invention. The same components as those of the first embodiment will be attached with the same symbols, and the description thereof will be omitted. In this embodiment, a single-phase power is input. A converter circuit 302, which receives the AC power and supplies the power to the motor, is configured by four diodes, converts a single-phase AC power input from the input terminals R and S into the DC power, and outputs the DC power to both electrodes of the smoothing capacitor 103. With the rectification of the diodes of the converter circuit 302, the DC voltage Vdc is generated in which a positive voltage is applied to the DC voltage line on the Node-P side, and a negative voltage is applied to the DC voltage line on the Node-N side. The smoothing capacitor 103 is connected to the DC voltage line at Nodes P and N, and smoothens the voltage between the lines. The inverter circuit 104 converts the DC power into the AC power to drive the motor, and outputs the AC power to output terminals U, V, and W.

The output terminals U, V, and W of the power conversion device 300 are connected to three motor cables MCu, MCv, and MCw, and then connected to a three-phase motor MT. On the other hand, the input terminals R and S of the power conversion device 300 are connected to two power cables TC, and then connected to the secondary side of a transformer TRN. The inner portion of the transformer TRN or any one of the cables TC is connected to the earth ET or a grounded line.

Similarly to the power conversion device of the first embodiment, the power conversion device of the third embodiment of the invention determines the ground fault site by the determination flow of the site of the ground fault illustrated in FIG. 2 and the processing flow of the ground fault current inspection illustrated in FIG. 3. However, the power conversion device of the third embodiment is input with the single AC power instead of three-phase AC power. Therefore, in the current ratio calculations S112 and S115 of FIG. 3, the current sufficient for the calculation can be measured, and the condition for success in the calculation of the current ratio is different. In the current ratio calculation S112, in order to measure the current sufficient for the calculation and to be successful in the calculation of the current ratio, there is a need to set at least one of the voltages to ground of the single-phase outputs of the transformer TRN to be positive. In addition, in the current ratio calculation S115, in order to measure the current sufficient for the calculation and to be successful in the calculation of the current ratio, there is a need to set at least one of the voltages to ground of the single-phase outputs of the transformer TRN to be negative.

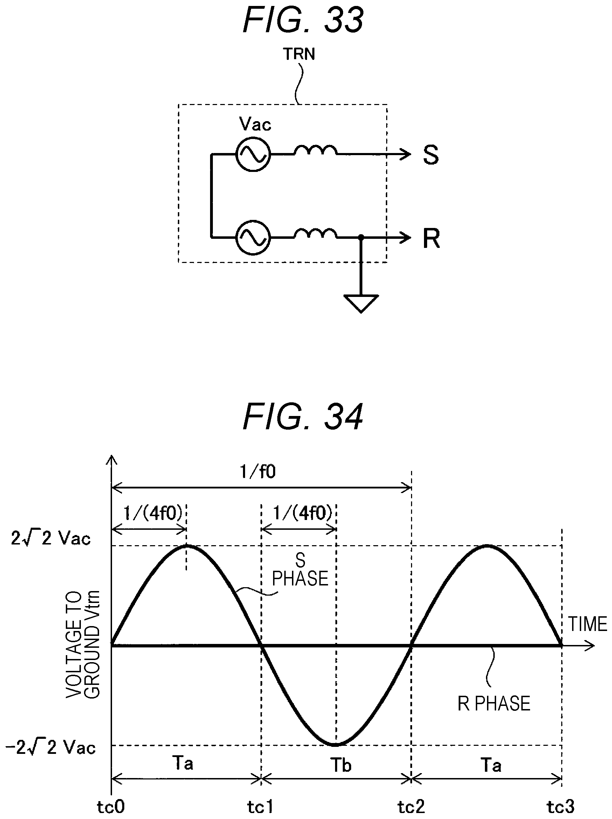

FIG. 33 is an equivalent circuit of the transformer in which one of single-phase output terminals is grounded and a phase voltage is "Vac". At this time, the voltages to ground of R and S phases of the secondary three-phase outputs of the transformer TRN when the output is in an open state are obtained as illustrated in FIG. 34. "f0" is a fundamental frequency of an AC power source, and is normally about several tens Hz. One period (= 1/f0) of an AC power source voltage includes Period Ta in which there are one or more phases having positive voltages to ground in the three phases, and Time Tb in which there are one or more phases having negative voltages to ground in the three phases. In a case where the switches of the upper arm are turned ON in Period Ta to perform the current ratio calculation S112, the sufficient current can be measured, and the current ratio calculation can be successful. In addition, in a case where the switches of the lower arm are turned ON in Period Tb to perform the current ratio calculation S115, the sufficient current can be measured, and the current ratio calculation can be successful. By the way, since the voltages of the R and S phases become almost "0" near the voltage zero-cross points at time tc0 to time tc3, both the current ratio calculations S112 and S115 may be not successful near times tc0 to tc3. Therefore, in the processing flow of the ground fault current inspection of FIG. 3, the current ratio calculations S112 and S115 are performed again at times deviated from tc0 to tc3 by standing by a certain period of time S117. Further, when the standby time is set to $1/(4 \cdot f0)$, the voltage is maximized at time after $1/(4 \cdot f0)$ from the second voltage zero-cross point. Therefore, it is possible to set the condition suitable for the current ratio calculation of the second time.

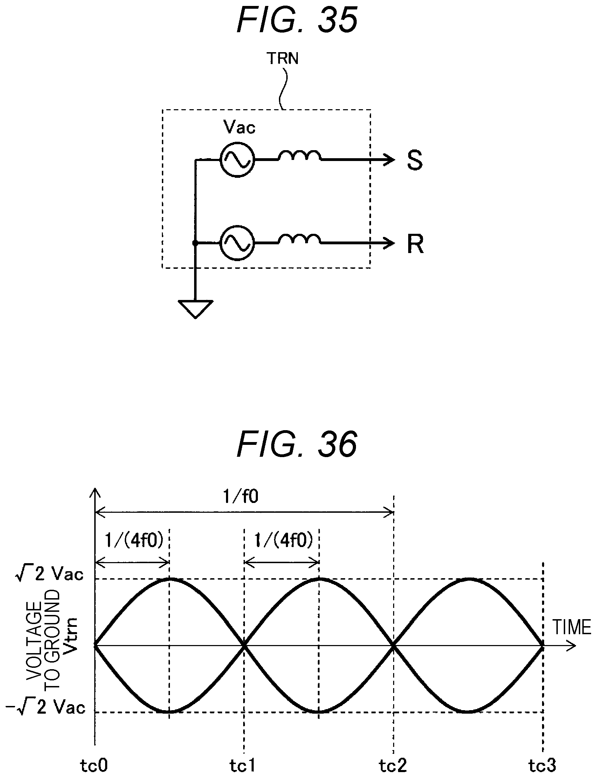

FIG. 35 is an equivalent circuit of the transformer in which the neutral point is grounded and the phase voltage is "Vac". At this time, the voltages to ground of R and S phases of the secondary three-phase outputs of the transformer TRN when the output is in an open state are obtained as illustrated in FIG. 34. Except near the voltage zero-cross point of times tc0 to tc3, there are phases in which one or more voltages to ground are positive and negative. Therefore, the sufficient current can be measured in both the current ratio calculation S112 when the switches of the upper arm are turned ON, and the current ratio calculation S115 when the switches of the lower arm are turned ON, and the current ratio calculation can be successful. Since the voltages of the R and S phases become almost "0" near the voltage zero-cross points at time tc0 to time tc3, both the current ratio calculations S112 and S115 may be not successful near times tc0 to tc3. Therefore, in the processing flow of the ground fault current inspection of FIG. 3, the current ratio calculations S112 and S115 are performed again at times deviated from tc0 to tc3 by standing by a certain period of time S117. Further, when the standby time is set to $1/(4 \cdot f0)$, the voltage is maximized at time after $1/(4 \cdot f0)$ from the second voltage zero-cross point. Therefore, it is possible to set the condition suitable for the current ratio calculation of the second time.

[Applications of the invention]

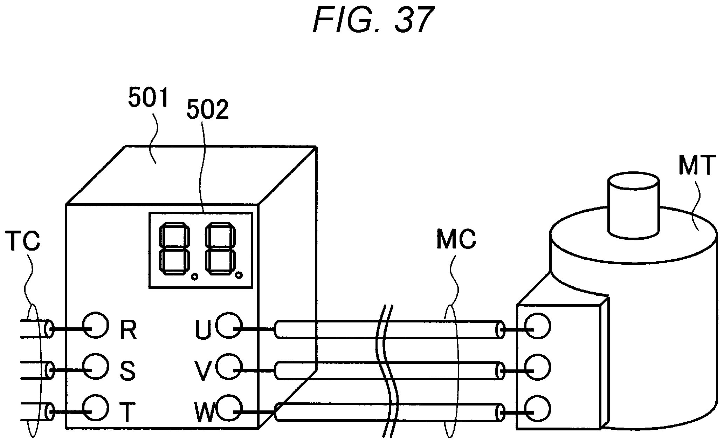

FIG. 37 illustrates an example in which the invention is applied to an industrial inverter. A power conversion device 501 and a drive motor MT of the invention are connected by the motor cable MC. The power conversion device 501 is supplied with power from the outer side through the AC power cable TC. The motor MT is used to drive various industrial machines such as an air conditioner, an air compressor, a conveyor, and an elevator. In a case where a ground fault occurs in the motor MT or on the cable MC, information of the short-circuit site is displayed in a display device 502 which is provided in the power conversion device 501, and the external system is notified of the short-circuit site in a wireless transmission.

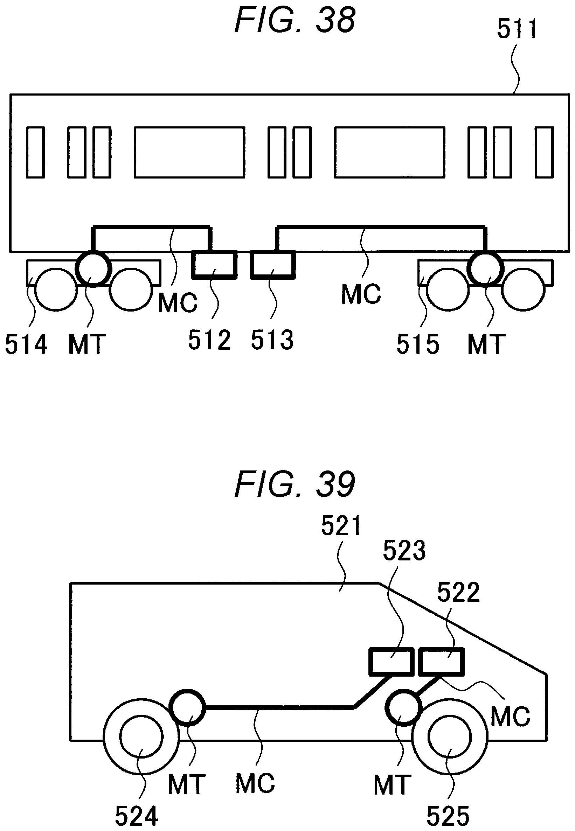

FIG. 38 illustrates an example in which the invention is applied to a railway vehicle. Power conversion devices 512 and 513 of the invention are provided below the floor of a railway vehicle 511. The drive motors MT are provided in dollies 514 and 515 of the railway vehicle 511. The motor and the power conversion device are connected by the motor cable MC. In a case where a ground fault occurs in the motor MT or on the motor cable MC, information of the short-circuit site is displayed in the display device which is provided in the power conversion devices 512 and 513, and the external system is notified of the ground fault site in a wireless transmission.

FIG. 39 illustrates an example in which the invention is applied to a vehicle equipped with an electric motor. Power conversion devices 522 and 523 of the invention are provided in a vehicle 521. In addition, the motors MT are provided to drive wheels 524 and 525, and connected by the power conversion device and the motor cable MC. In a case where a ground fault occurs in the motor MT or on the motor cable MC, information of the short-circuit site is displayed in the display device which is provided in the power conversion devices 522 and 523, and the external system is notified of the short-circuit site in a wireless transmission.

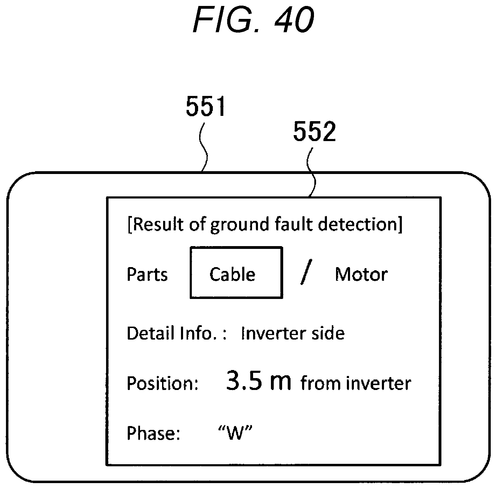

FIG. 40 illustrates an example of the tablet terminal which displays the determination result of the ground fault of the invention. A tablet terminal 551 includes a liquid crystal display screen 552, and an installed application causes the liquid crystal display screen 552 to display information of the ground fault site according to a received code.

Reference Signs List

SW, SWu, SWv, SWw, SWx, SWy, SWz switch
DI, DIu, DIv, DIw, DIx, DIy, DIz diode
SD, SDu, SDv, SDw, SDx, SDy, SDz switch drive circuit (driver circuit)
MC, MCu, MCv, MCw motor cable
MT motor
TC power cable
TRN transformer
ET earth and neutral line
100 power conversion device
102 converter circuit
103 smoothing capacitor

104 inverter circuit
105 control circuit
106 input device
107 receiver
108 display device
109 transmitter
110u, 110v, 110w current sensor
111 current measurement circuit
121 current ratio calculation unit
122 inductance value storage unit
123 ground fault site determination unit
131 decoder
132 LED driver
133 LED segment
141 modulator
142 amplifier
143 antenna
151 logical circuit
152 gate drive amplifier
153 gate resistor
154 comparator
155 capacitor
156 capacitor charging resistor
157 capacitor discharging switch
158 diode
159, 160 constant-voltage source

## Claims

1. A power conversion device (100) which includes a plurality of semiconductor switch elements and drives a three-phase motor (MT) connected by three-phase cables by controlling the switch elements on or off, the power conversion device comprising:

   a converter circuit (102), which is configured to convert an AC power from a power source into a DC power;
   an inverter circuit (104), which is configured by three half bridge circuits to control a current which is supplied to the motor;
   a plurality of driver circuits, which are configured to drive a plurality of switch elements of the half bridge circuit;
   a control circuit (105), which is configured to control the driver circuit;
   a current measurement unit (111), which is configured to measure output current values of a plurality of phases of the inverter circuit; and
   an information output unit (108), which is configured to notify an outer side of an inner situation of the power conversion device,
   wherein respective ground loops exist between the power source, each phase of the three-phase motor, and inverter circuit; and
   wherein, when a ground fault site occurring in the cable or the motor is inspected, and the power conversion device is **characterized by**:

      the inverter circuit being configured to simultaneously turn on the plurality of switch elements of any one of upper arms and lower arms of the three half bridge circuits to generate a current to the plurality of connection cables,
      the current measurement unit being configured to measure output current values of a plurality of phases in a period when the switch elements are simultaneously turned on or immediately after the period,
      the control circuit being configured to determine a ground fault site on the basis of a current ratio of a maximum value and a minimum value of the output current values of the plurality of phases, such as to determine a location of the ground fault on the cable and/or inside the motor; wherein the maximum current is derived from a current measurement in a ground current loop including the faulty phase, and the minimum value of the output current value is derived from a current measurement in a ground current loop not including the faulty phase, and

the information output unit notifies an outer side of a result of the determination.

2. The power conversion device according to claim 1,
wherein the inverter circuit is configured to simultaneously turn on three switch elements of any one of the upper arms and the lower arms of the three half bridge circuits to generate a current to the three connection cables.

3. The power conversion device according to claim 1,
wherein the inverter circuit is configured to simultaneously turn on two switch elements of any one of the upper arms and the lower arms of the three half bridge circuits to generate a current to two of the connection cables.

4. The power conversion device according to claim 1,
wherein the control circuit is configured to determine a phase in which an output current value is largest is a phase where a ground fault occurs.

5. The power conversion device according to claim 1,
wherein the driver circuit includes an overcurrent detection circuit which is configured to detect an overcurrent when the output current value exceeds an overcurrent threshold, and has an overcurrent protection function in which the switch element is automatically turned off when an overcurrent is detected.

6. The power conversion device according to claim 5,
wherein, in a case where an increasing speed of the output current in a period when the plurality of switch elements are turned on is fast, the control circuit is configured to determine, as a maximum current phase, a phase in which there is an overcurrent protection circuit which first detects an overcurrent among the plurality of overcurrent protection circuits.

7. The power conversion device according to claim 1,
wherein the current measurement unit includes current sensors which are configured to measure output current amounts of three phases, and current measurement circuits which are configured to read current values of the current sensors and transmit the current values measured in the respective phases to the control circuit.

8. The power conversion device according to claim 7,
wherein the control circuit is configured to compare the measured current values, and calculate the current ratio from a maximum value and a minimum value of the measured current values.

9. The power conversion device according to claim 1,
wherein the current measurement unit includes current sensors which are configured to measure output current amounts of two phases, and current measurement circuits which are configured to read current values of the current sensors and transmit the current values measured in the respective phases to the control circuit.

10. The power conversion device according to claim 9,
wherein the control circuit is configured to compare the measured current values, calculate the current ratio from a maximum value and a minimum value of the measured current values in a case where the values are significantly different, measure again a current in a phase different from a phase where an overcurrent is detected at timing of detecting the overcurrent in a case where the values are almost equal, and calculate a ratio of an overcurrent threshold and the measured current value as the current ratio.

11. The power conversion device according to claim 1,
wherein the control circuit includes a storage unit which is configured to store inductance value information of the cable and inductance value information of the motor, and determine whether a ground fault site is on the cable or on the motor on the basis of the stored information and the current ratio.

12. The power conversion device according to claim 11,
wherein the current ratio is a value obtained by dividing a minimum current value by a maximum current value, the ground fault site is determined to be on the cable in a case where the current ratio is smaller than a threshold value obtained from a plurality of pieces of the inductance value information, and the ground fault site is determined to be on the motor in a case where the current ratio is larger than the threshold.

**13.** The power conversion device according to claim 12,
wherein a ground fault position on the cable and on the motor is specified from a ratio of the current ratio to the threshold.

**14.** A method for determining a ground fault site of a cable or a motor connected to a power conversion device which drives a three-phase motor, the power conversion device including a converter circuit which converts an AC power from a power source into a DC power, an inverter circuit which is configured by three half bridge circuits to control a current which is supplied to the motor, a plurality of driver circuits which are used to drive a plurality of switch elements of the half bridge circuit, a control circuit which is used to control the driver circuit, and a current measurement unit which measures output current values of a plurality of phases of the inverter circuit; and an information output unit, which notifies an outer side of an inner situation of the power conversion device, wherein respective ground loops exist between the power source, each phase of the three-phase motor, and inverter circuit; and wherein, when a ground fault site occurring in the cable or the motor is inspected, **characterized in that** the method further comprises:

turning on the plurality of switch elements of any one of upper arms and lower arms of the three half bridge circuits to generate a current to the plurality of connection cables;
measuring output current values of a plurality of phases in a period when the switch elements are simultaneously turned on or immediately after the period; and
determining a ground fault site on the basis of a current ratio of a maximum value and a minimum value of the output current values of the plurality of phases, such as to determine a location of the ground fault on the cable and/or inside the motor; wherein the maximum current is derived from a current measurement in a ground current loop including the faulty phase, and the minimum value of the output current value is derived from a current measurement in a ground current loop not including the faulty phase, and the information output unit notifies an outer side of a result of the determination.

**15.** The method for determining the ground fault site according to claim 14,
wherein, in the determining of the ground fault site, a threshold determined on the basis of inductance value information of the cable and inductance value information of the motor is compared with a current ratio of a maximum value and a minimum value of the output current values of the plurality of phases to determine the ground fault site.

**Patentansprüche**

**1.** Leistungswandlervorrichtung (100), die eine Vielzahl von Halbleiterschaltelementen umfasst und einen Drehstrommotor (MT) ansteuert, der durch Dreiphasenkabel angeschlossen ist, indem die Schaltelemente ein- oder ausgeschaltet werden, wobei die Leistungswandlervorrichtung Folgendes umfasst:

eine Wandlerschaltung (102), die konfiguriert ist, um eine Wechselstromleistung von einer Leistungsquelle in eine Gleichstromleistung umzuwandeln;
eine Wechselrichterschaltung (104), die durch drei Halbbrückenschaltungen konfiguriert ist, um einen Strom zu steuern, der dem Motor zugeführt wird;
eine Vielzahl von Treiberschaltungen, die konfiguriert sind, um eine Vielzahl von Schaltelementen der Halbbrückenschaltung anzusteuern;
eine Steuerungsschaltung (105), die konfiguriert ist, um die Treiberschaltung zu steuern;
eine Strommesseinheit (111), die konfiguriert ist, um ausgegebene Stromwerte einer Vielzahl von Phasen der Wechselrichterschaltung zu messen; und
eine Informationsausgabeeinheit (108), die konfiguriert ist, um eine Außenseite bezüglich einer Innensituation der Leistungswandlervorrichtung zu benachrichtigen;
wobei entsprechende Masseschleifen zwischen der Leistungsquelle, jeder Phase des Drehstrommotors und der Wechselrichterschaltung bestehen; und
wobei, wenn eine in dem Kabel oder dem Motor Fehlerstromstelle auftritt sie untersucht wird, und die Leistungswandlervorrichtung **dadurch gekennzeichnet ist, dass**:

die Wechselrichterschaltung konfiguriert ist, um die Vielzahl von Schaltelementen von einem beliebigen von oberen Zweigen und unteren Zweigen der drei Halbbrückenschaltungen gleichzeitig einzuschalten, um einen Strom zu der Vielzahl an Verbindungskabeln zu erzeugen,
die Strommesseinheit konfiguriert ist, um ausgegebene Stromwerte einer Vielzahl von Phasen in einer Zeitspanne, wenn die Schaltelemente gleichzeitig eingeschaltet sind, oder unmittelbar nach der Zeitspanne zu messen,

die Steuerungsschaltung konfiguriert ist, um eine Fehlerstromstelle auf Basis eines Stromverhältnisses eines Maximalwerts und eines Mindestwerts der ausgegebenen Stromwerte der Vielzahl von Phasen zu bestimmen, etwa um eine Position des Fehlerstroms auf dem Kabel und/oder im Inneren des Motors zu bestimmen; wobei der Maximalstrom von einer Strommessung in einer Strom-Masseschleife einschließlich der fehlerhaften Phase abgeleitet ist und der Mindestwert des ausgegebenen Stromwerts von einer Strommessung in einer Strom-Masseschleife ohne die fehlerhafte Phase abgeleitet ist, und

die Informationsausgabeeinheit eine Außenseite von dem Ergebnis der Bestimmung benachrichtigt.

2. Leistungswandlervorrichtung nach Anspruch 1, wobei die Wechselrichterschaltung konfiguriert ist, um gleichzeitig drei Schaltelemente eines beliebigen der oberen Zweige und der unteren Zweige der drei Halbbrückenschaltungen einzuschalten, um einen Strom zu den drei Verbindungskabeln zu erzeugen.

3. Leistungswandlervorrichtung nach Anspruch 1, wobei die Wechselrichterschaltung konfiguriert ist, um gleichzeitig zwei Schaltelemente eines beliebigen der oberen Zweige und der unteren Zweige der drei Halbbrückenschaltungen einzuschalten, um einen Strom zu zwei der Verbindungskabel zu erzeugen.

4. Leistungswandlervorrichtung nach Anspruch 1, wobei die Steuerungsschaltung konfiguriert ist, um zu bestimmen, dass eine Phase, in der ein ausgegebener Stromwert am größten ist, eine Phase ist, in der ein Fehlerstrom auftritt.

5. Leistungswandlervorrichtung nach Anspruch 1, wobei die Treiberschaltung eine Überstromdetektionsschaltung umfasst, die konfiguriert ist, um einen Überstrom zu detektieren, wenn der ausgegebene Stromwert eine Überstromschwelle übersteigt, und eine Überstromschutzfunktion aufweist, in der das Schaltelement automatisch abgeschaltet wird, wenn ein Überstrom detektiert wird.

6. Leistungswandlervorrichtung nach Anspruch 5, wobei die Steuerungsschaltung in einem Fall, in dem eine zunehmende Geschwindigkeit des ausgegebenen Stroms in einer Zeitspanne, in der die Vielzahl von Schaltelementen eingeschaltet sind, schnell ist, konfiguriert ist, um als Maximalstromphase eine Phase zu bestimmen, in der eine Überstromschutzschaltung vorhanden ist, die einen Überstrom in der Vielzahl von Überstromschutzschaltungen als erstes detektiert.

7. Leistungswandlervorrichtung nach Anspruch 1, wobei die Strommesseinheit Stromsensoren umfasst, die konfiguriert sind, um die ausgegebenen Strommengen von drei Phasen zu messen, und Strommessschaltungen umfasst, die konfiguriert sind, um Stromwerte der Stromsensoren auszulesen und die in den entsprechenden Phasen gemessenen Stromwerte an die Steuerungsschaltung zu übertragen.

8. Leistungswandlervorrichtung nach Anspruch 7, wobei die Steuerungsschaltung konfiguriert ist, um die gemessenen Stromwerte zu vergleichen und das Stromverhältnis aus einem Maximalwert und einem Mindestwert der gemessenen Stromwerte zu berechnen.

9. Leistungswandlervorrichtung nach Anspruch 1, wobei die Strommesseinheit Stromsensoren umfasst, die konfiguriert sind, um die ausgegebenen Stromwerten von zwei Phasen zu messen, und Strommessschaltungen umfasst, die konfiguriert sind, um Stromwerte der Stromsensoren auszulesen und die in den entsprechenden Phasen gemessenen Stromwerte an die Steuerungsschaltung zu übertragen.

10. Leistungswandlervorrichtung nach Anspruch 9, wobei die Steuerungsschaltung konfiguriert ist, um die gemessenen Stromwerte zu vergleichen, in einem Fall, in dem die Werte sich signifikant unterscheiden, das Stromverhältnis aus einem Maximalwert und einem Mindestwert der gemessenen Stromwerte zu berechnen, in einem Fall, in dem die Werte fast gleich sind, einen Strom in einer Phase, die sich von einer Phase unterscheidet, in der ein Überstrom detektiert wird, zum Zeitpunkt der Detektion des Überstroms erneut zu messen, und ein Verhältnis eines Überstromschwellenwerts und des gemessenen Stromwerts als Stromverhältnis zu berechnen.

11. Leistungswandlervorrichtung nach Anspruch 1, wobei die Steuerungsschaltung eine Speichereinheit umfasst, die konfiguriert ist, um Induktivitätswertinformationen des Kabels und Induktivitätswertinformationen des Motors zu speichern und auf Basis der gespeicherten Informationen und des Stromverhältnisses zu bestimmen, ob sich eine Fehlerstromstelle auf dem Kabel oder auf dem Motor befindet.

**12.** Leistungswandlervorrichtung nach Anspruch 11, wobei das Stromverhältnis ein Wert ist, der erhalten wird, indem ein Mindeststromwert durch einen Maximalstromwert dividiert wird, die Fehlerstromstelle als auf dem Kabel befindlich bestimmt wird, wenn das Stromverhältnis unter einem Schwellenwert liegt, der aus einer Vielzahl von Induktivitätswertinformationen erhalten wurde, und die Fehlerstromstelle als auf dem Motor befindlich bestimmt ist, wenn das Stromverhältnis über dem Schwellenwert liegt.

**13.** Leistungswandlervorrichtung nach Anspruch 12, wobei die Fehlerstromposition auf dem Kabel und auf dem Motor aus einem Verhältnis des Stromverhältnisses zum Schwellenwert spezifiziert wird.

**14.** Verfahren zur Bestimmung einer Fehlerstromstelle eines Kabels oder Motors, das/der mit einer einen Drehstrommotor antreibenden Leistungswandlervorrichtung verbunden ist, wobei die Leistungswandlervorrichtung Folgendes umfasst: eine Wandlerschaltung, die eine Wechselstromleistung von einer Leistungsquelle in eine Gleichstromleistung umwandelt; eine Wechselrichterschaltung, die durch drei Halbbrückenschaltungen konfiguriert ist, um einen Strom zu steuern, der dem Motor zugeführt wird; eine Vielzahl von Treiberschaltungen, die verwendet werden, um eine Vielzahl von Schaltelementen der Halbbrückenschaltung anzusteuern; eine Steuerungsschaltung, die verwendet wird, um die Treiberschaltung zu steuern; eine Strommesseinheit, die ausgegebene Stromwerte einer Vielzahl von Phasen der Wechselrichterschaltung misst; und eine Informationsausgabeeinheit, die eine Außenseite bezüglich einer Innensituation der Leistungswandlervorrichtung benachrichtigt; wobei entsprechende Masseschleifen zwischen der Leistungsquelle, jeder Phase des Drehstrommotors und der Wechselrichterschaltung bestehen; und wobei, wenn eine in dem Kabel oder dem Motor Fehlerstromstelle auftritt sie untersucht wird,
**dadurch gekennzeichnet, dass** das Verfahren ferner Folgendes umfasst
das Einschalten der Vielzahl von Schaltelementen von einem beliebigen von oberen Zweigen und von unteren Zweigen der drei Halbbrückenschaltungen, um einen Strom zu der Vielzahl an Verbindungskabeln zu erzeugen,
das Messen von ausgegebenen Stromwerten einer Vielzahl von Phasen in einer Zeitspanne, wenn die Schaltelemente gleichzeitig eingeschaltet sind, oder unmittelbar nach der Zeitspanne; und
das Bestimmen einer Fehlerstromstelle auf Basis eines Stromverhältnisses eines Maximalwerts und eines Mindestwerts der ausgegebenen Stromwerte der Vielzahl von Phasen, etwa um eine Position des Fehlerstroms auf dem Kabel und/oder im Inneren des Motors zu bestimmen; wobei der Maximalstrom von einer Strommessung in einer Strom-Masseschleife einschließlich der fehlerhaften Phase abgeleitet ist und der Mindestwert des ausgegebenen Stromwerts von einer Strommessung in einer Strom-Masseschleife ohne die fehlerhafte Phase zu bestimmen, abgeleitet wird, und die Informationsausgabeeinheit eine Außenseite von dem Ergebnis der Bestimmung benachrichtigt.

**15.** Verfahren zur Bestimmung einer Fehlerstromstelle nach Anspruch 14, wobei bei der Bestimmung der Fehlerstromstelle ein Schwellenwert, der auf Basis von Induktivitätswertinformationen des Kabels und Induktivitätswertinformationen des Motors mit einem Stromverhältnis eines Maximalwerts und eines Mindestwerts der ausgegebenen Stromwerte der Vielzahl von Phasen verglichen wird, um die Fehlerstromstelle zu bestimmen.

## Revendications

**1.** Dispositif de conversion de puissance (100) qui inclut une pluralité d'éléments de commutation à semi-conducteurs et entraîne un moteur triphasé (MT) connecté par câbles triphasés en commandant la mise sur marche ou arrêt des éléments de commutation, le dispositif de conversion de puissance comprenant :

un circuit convertisseur (102), qui est configuré pour convertir une puissance CA d'une source d'alimentation en une puissance CC ;
un circuit onduleur (104), qui est configuré par des trois circuits en demi-pont pour contrôler un courant qui est fourni au moteur ;
une pluralité de circuits d'excitation, qui sont configurés pour exciter une pluralité d'éléments de commutation du circuit en demi-pont ;
un circuit de commande (105), qui est configuré pour commander le circuit d'excitation ;
une unité de mesure de courant (111), qui est configurée pour mesurer les valeurs de courant de sortie d'une pluralité de phases du circuit onduleur ; et
une unité de sortie d'informations (108), qui est configurée pour notifier un côté externe d'une situation interne du dispositif de conversion de puissance,
dans lequel des boucles de terre respectives existent entre la source de puissance, chaque phase du moteur triphasé et le circuit onduleur ; et

dans lequel, lorsqu'un site de défaut de terre survenant dans le câble ou le moteur est inspecté, et le dispositif de conversion de puissance est **caractérisé en ce que** :

le circuit onduleur est configuré pour mettre simultanément sur marche la pluralité d'éléments de commutation de l'un quelconque de bras supérieurs et de bras inférieurs des trois circuits en demi-pont pour générer un courant vers la pluralité de câbles de connexion,

l'unité de mesure de courant est configurée pour mesurer des valeurs de courant de sortie d'une pluralité de phases dans une période où les éléments de commutation sont mis simultanément sur marche ou immédiatement après la période ;

le circuit de commande est configuré pour déterminer un site de défaut de terre sur la base d'un rapport de courant d'une valeur maximale et d'une valeur minimale des valeurs de courant de sortie de la pluralité de phases, de telle sorte à déterminer un emplacement du défaut de terre sur le câble et/ou à l'intérieur du moteur ; dans lequel le courant maximal est dérivé d'une mesure de courant dans une boucle de courant de terre incluant la phase défectueuse, et la valeur minimale de la valeur de courant de sortie est dérivée d'une mesure de courant dans une boucle de courant de terre n'incluant pas la phase défectueuse, et l'unité de sortie d'informations notifie à un côté externe un résultat de la détermination.

2. Dispositif de conversion de puissance selon la revendication 1,
dans lequel le circuit onduleur est configuré pour mettre simultanément sur marche trois éléments de commutation de l'un quelconque des bras supérieurs et des bras inférieurs des trois circuits en demi-pont pour générer un courant vers les trois câbles de connexion.

3. Dispositif de conversion de puissance selon la revendication 1,
dans lequel le circuit onduleur est configuré pour mettre simultanément sur marche deux éléments de commutation de l'un quelconque des bras supérieurs et des bras inférieurs des trois circuits en demi-pont pour générer un courant vers deux des câbles de connexion.

4. Dispositif de conversion de puissance selon la revendication 1,
dans lequel le circuit de commande est configuré pour déterminer qu'une phase dans laquelle une valeur de courant de sortie est la plus grande est une phase où survient un défaut de terre.

5. Dispositif de conversion de puissance selon la revendication 1,
dans lequel le circuit d'excitation inclut un circuit de détection de surintensité qui est configuré pour détecter une surintensité lorsque la valeur de courant de sortie dépasse un seuil de surintensité, et a une fonction de protection contre les surintensités dans laquelle l'élément de commutation est automatiquement mis sur arrêt lorsqu'une surintensité est détectée.

6. Dispositif de conversion de puissance selon la revendication 5,
dans lequel, dans un cas où une vitesse d'augmentation du courant de sortie dans une période où la pluralité d'éléments de commutation sont mis sur marche est rapide, le circuit de commande est configuré pour déterminer, en tant que phase de courant maximale, une phase dans laquelle il existe un circuit de protection contre les surintensités qui détecte en premier une surintensité parmi la pluralité de circuits de protection contre les surintensités.

7. Dispositif de conversion de puissance selon la revendication 1,
dans lequel l'unité de mesure de courant inclut des capteurs de courant qui sont configurés pour mesurer des quantités de courant de sortie de trois phases, et des circuits de mesure de courant qui sont configurés pour lire des valeurs de courant des capteurs de courant et transmettre les valeurs de courant mesurées dans les phases respectives au circuit de commande.

8. Dispositif de conversion de puissance selon la revendication 7,
dans lequel le circuit de commande est configuré pour comparer les valeurs de courant mesurées, et calculer le rapport de courant à partir d'une valeur maximale et d'une valeur minimale des valeurs de courant mesurées.

9. Dispositif de conversion de puissance selon la revendication 1,
dans lequel l'unité de mesure de courant inclut des capteurs de courant qui sont configurés pour mesurer des quantités de courant de sortie de deux phases, et des circuits de mesure de courant qui sont configurés pour lire des valeurs de courant des capteurs de courant et transmettre les valeurs de courant mesurées dans les phases respectives au circuit de commande.

**10.** Dispositif de conversion de puissance selon la revendication 9,
dans lequel le circuit de commande est configuré pour comparer les valeurs de courant mesurées, calculer le rapport de courant à partir d'une valeur maximale et d'une valeur minimale des valeurs de courant mesurées dans un cas où les valeurs sont significativement différentes, mesurer à nouveau un courant dans une phase différente d'une phase où une surintensité est détectée au moment de détection de la surintensité dans un cas où les valeurs sont presque égales, et calculer un rapport d'un seuil de surintensité et de la valeur de courant mesurée en tant que rapport de courant.

**11.** Dispositif de conversion de puissance selon la revendication 1,
dans lequel le circuit de commande inclut une unité de stockage qui est configurée pour stocker des informations de valeur d'inductance du câble et des informations de valeur d'inductance du moteur, et déterminer si un site de défaut de terre se trouve sur le câble ou sur le moteur sur la base des informations stockées et du rapport de courant.

**12.** Dispositif de conversion de puissance selon la revendication 11,
dans lequel le rapport de courant est une valeur obtenue en divisant une valeur de courant minimale par une valeur de courant maximale, le site de défaut de terre est déterminé comme se trouvant sur le câble dans un cas où le rapport de courant est plus petit qu'une valeur seuil obtenue d'une pluralité d'éléments d'information de valeur d'inductance, et le site de défaut de terre est déterminé comme se trouvant sur le moteur dans un cas où le rapport de courant est plus grand que le seuil.

**13.** Dispositif de conversion de puissance selon la revendication 12,
dans lequel une position de défaut de terre sur le câble et sur le moteur est spécifiée à partir d'un rapport du rapport de courant sur le seuil.

**14.** Procédé de détermination d'un site de défaut de terre d'un câble ou d'un moteur connecté à un dispositif de conversion de puissance qui entraîne un moteur triphasé, le dispositif de conversion de puissance incluant un circuit convertisseur qui convertit une puissance CA d'une source de puissance en une puissance CC, un circuit onduleur qui est configuré par trois circuits en demi-pont pour contrôler un courant qui est fourni au moteur, une pluralité de circuits d'excitation qui sont utilisés pour exciter une pluralité d'éléments de commutation du circuit en demi-pont, un circuit de commande qui est utilisé pour commander le circuit d'excitation, et une unité de mesure de courant qui mesure des valeurs de courant de sortie d'une pluralité de phases du circuit onduleur ; et une unité de sortie d'informations, qui notifie à un côté externe une situation interne du dispositif de conversion de puissance, dans lequel des boucles de terre respectives existent entre la source de puissance, chaque phase du moteur triphasé, et le circuit onduleur ; et dans lequel, lorsqu'un site de défaut de terre survenant dans le câble ou le moteur est inspecté,
**caractérisé en ce que** le procédé comprend en outre :

la mise sur marche de la pluralité d'éléments de commutation de l'un quelconque des bras supérieurs et des bras inférieurs des trois circuits en demi-pont pour générer un courant vers la pluralité de câbles de connexion ;
la mesure de valeur de courant de sortie d'une pluralité de phases dans une période où les éléments de commutation sont mis simultanément sur marche ou immédiatement après la période ; et
la détermination d'un site de défaut de terre sur la base d'un rapport de courant d'une valeur maximale et d'une valeur minimale des valeurs de courant de sortie de la pluralité de phases, de telle sorte à déterminer un emplacement d'un défaut de terre sur le câble et/ou à l'intérieur du moteur ; dans lequel le courant maximal est dérivé d'une mesure de courant dans une boucle de courant de terre incluant la phase défectueuse, et la valeur minimale de la valeur de courant de sortie est dérivée d'une mesure de courant dans une boucle de courant de terre n'incluant pas la phase défectueuse, et l'unité de sortie d'informations notifie à un côté externe un résultat de la détermination.

**15.** Procédé de détermination du site de défaut de terre selon la revendication 14,
dans lequel, dans la détermination du site de défaut de terre, un seuil déterminé sur la base d'informations de valeur d'inductance du câble et d'informations de valeur d'inductance du moteur est comparé à un rapport de courant d'une valeur maximale et d'une valeur minimale des valeurs de courant de sortie de la pluralité de phases pour déterminer le site de défaut de terre.

*FIG. 1*

# FIG. 2

FLOW OF DETERMINING
SITE OF GROUND FAULT

```
        ┌─────────────────────────┐
        │          START          │
        └─────────────────────────┘
                     │
        ┌─────────────────────────┐
S101    │        STOP MOTOR        │
        └─────────────────────────┘
                     │
        ┌─────────────────────────┐
        │      GROUND FAULT        │
S102    │        CURRENT           │
        │       INSPECTION         │
        └─────────────────────────┘
                     │
        ┌─────────────────────────┐
S103    │    DETERMINE GROUND      │
        │       FAULT SITE         │
        └─────────────────────────┘
                     │
        ┌─────────────────────────┐
S104    │       DISPLAY AND        │
        │     TRANSMIT RESULT       │
        └─────────────────────────┘
                     │
        ┌─────────────────────────┐
        │           END           │
        └─────────────────────────┘
```

# FIG. 3

FLOW OF INSPECTING GROUND FAULT CURRENT

```
         ┌─────────────────────┐
         │        START        │
         └─────────────────────┘
                    │
S111 ────┌─────────────────────┐
         │      TURN ON         │
         │   SWu, SWv, SWw      │
         └─────────────────────┘
                    │
S112 ────┌─────────────────────┐
         │   CURRENT RATIO      │
         │    CALCULATION       │
         └─────────────────────┘
                    │
S113 ────◇─────────────────────◇────── Y
         │    IS SUCCESS        │
         │    FLAG SET ON?      │
         ◇─────────────────────◇
                    │ N
S114 ────┌─────────────────────┐
         │      TURN ON         │
         │   SWx, SWy, SWz      │
         └─────────────────────┘
                    │
S115 ────┌─────────────────────┐
         │   CURRENT RATIO      │
         │    CALCULATION       │
         └─────────────────────┘
                    │
S116 ────◇─────────────────────◇────── Y
         │    IS SUCCESS        │
         │    FLAG SET ON?      │
         ◇─────────────────────◇
                    │ N
S117 ────┌─────────────────────┐
         │     STAND BY         │
         │   CERTAIN TIME       │
         └─────────────────────┘
                    │
         ┌─────────────────────┐
         │         END          │
         └─────────────────────┘
```

# FIG. 4

# FIG. 5

FIG. 6

# FIG. 7

# FIG. 8

# FIG. 9

## FIG. 10

## FIG. 11

## FIG. 12

## FIG. 13

FIG. 14

FIG. 15

| (A)CODE | (B) LED INDICATION | (C) GROUND FAULT SITE INFORMATION |
|---|---|---|
| A1 | A 1 | NEAR INVERTER ON CABLE (U PHASE) |
| A2 | A2 | 〃 (V PHASE) |
| A3 | A3 | 〃 (W PHASE) |
| b1 | b 1 | NEAR MOTOR ON CABLE (U PHASE) |
| b2 | b2 | 〃 (V PHASE) |
| b3 | b3 | 〃 (W PHASE) |
| C1 | C 1 | NEAR TERMINAL IN MOTOR (U PHASE) |
| C2 | C2 | 〃 (V PHASE) |
| C3 | C3 | 〃 (W PHASE) |
| d1 | d 1 | NEAR NEUTRAL POINT IN MOTOR (U PHASE) |
| d2 | d2 | 〃 (V PHASE) |
| d3 | d3 | 〃 (W PHASE) |
| 00 TO 99 | 00 TO 99 | DISTANCE FROM INVERTER (m) |

# FIG. 16

# FIG. 17

# FIG. 18

FLOW OF CALCULATING CURRENT RATIO

# FIG. 19

## FIG. 20

EP 3 477 843 B1

# FIG. 21

FLOW OF CALCULATING CURRENT RATIO

# FIG. 22

FLOW OF DETERMINING
SITE OF GROUND FAULT

# FIG. 23

FLOW OF INSPECTING GROUND FAULT CURRENT

# FIG. 24

# FIG. 25

# FIG. 26

FIG. 27

EP 3 477 843 B1

## FIG. 28

## FIG. 29

# FIG. 30

# FIG. 31

FLOW OF CALCULATING V-W CURRENT RATIO

# FIG. 32

EP 3 477 843 B1

# FIG. 33

TRN

Vac

S

Vac

R

# FIG. 34

$1/f0$

$1/(4f0)$    $1/(4f0)$

$2\sqrt{2}\ Vac$

S PHASE

VOLTAGE TO GROUND Vtrn

TIME

R PHASE

$-2\sqrt{2}\ Vac$

Ta    Tb    Ta

tc0    tc1    tc2    tc3

# FIG. 35

TRN

Vac

S

R

# FIG. 36

1/f0

1/(4f0)    1/(4f0)

√2 Vac

VOLTAGE TO GROUND Vtrn

TIME

-√2 Vac

tc0    tc1    tc2    tc3

FIG. 37

## FIG. 38

511

514  MT          512  513          515  MT

## FIG. 39

521   523
      522

524          525

# FIG. 40

551

552

[Result of ground fault detection]

Parts | Cable | / Motor

Detail Info. : Inverter side

Position: 3.5 m from inverter

Phase: "W"

FIG. 41

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10023795 A
- US 20130293988 A1
- US 20080084215 A1